# EUROPEAN PATENT SPECIFICATION

(11) **EP 4 350 777 B1**
(45) Date of publication and mention of the grant of the patent: **11.11.2026**
(21) Application number: 23743247.1
(22) Date of filing: 17.01.2023
(51) Int. Cl.: H10D 12/01, H10D 12/00, H10D 8/00, H10D 62/10, H10D 62/13, H10D 62/60, H10D 64/00, H10D 84/80, H10P 30/20, H10W 10/00

(54) **POWER SEMICONDUCTOR DEVICE WITH IMPROVED END REGIONS FOR TRENCH GATES**
LEISTUNGSHALBLEITERBAUELEMENT MIT VERBESSERTEN ENDBEREICHEN FÜR TRENCH-GATES
DISPOSITIF SEMI-CONDUCTEUR DE PUISSANCE AVEC DES RÉGIONS D'EXTRÉMITÉ DES GRILLES EN TRANCHÉE AMÉLIORÉES

(30) Priority: 20.01.2022 JP 2022006926
(43) Date of publication of application: 10.04.2024
(73) Proprietor: Fuji Electric Co., Ltd., Kawasaki-shi, Kanagawa 210-9530 (JP)
(72) Inventor: SAKURAI, Yosuke, Kawasaki-shi, Kanagawa 210-9530 (JP); NOGUCHI, Seiji, Kawasaki-shi, Kanagawa 210-9530 (JP); YOSHIDA, Kosuke, Kawasaki-shi, Kanagawa 210-9530 (JP); HAMASAKI, Ryutaro, Kawasaki-shi, Kanagawa 210-9530 (JP); YAMADA, Takuya, Kawasaki-shi, Kanagawa 210-9530 (JP)
(74) Representative: MERH-IP Matias Erny Reichl Hoffmann Patentanwälte PartG mbB
(86) International application number: PCT/JP2023/001200
(87) International publication number: WO 2023/140253

(56) References cited:
- WO-A1-2022/123923
- WO-A1-2022/158053
- WO-A1-2022/239284
- WO-A1-2022/239285
- CN-A- 113 054 012
- JP-A- 2005 142 243
- JP-A- 2014 064 005
- JP-A- 2018 037 696
- JP-A- 2019 102 554
- JP-A- 2019 216 223
- JP-A- 2021 150 406
- US-A1- 2004 178 441
- US-A1- 2006 289 928
- US-A1- 2016 225 884
- US-A1- 2017 117 397
- US-A1- 2021 043 759
- US-A1- 2021 296 487

## Description

### BACKGROUND

### 1. TECHNICAL FIELD

The present invention relates to a semiconductor device.

### 2. RELATED ART

A structure has been hitherto known in which a floating region of a P type away from a well region of the P type is provided at a bottom portion of a gate trench (see Patent Document 1, for example).

Patent document 2 relates to an insulated-gate-type semiconductor device. In this semiconductor device, a surface region of a first base layer includes a second base layer. Trenches are formed from the surface of the second base layer down to the first base layer. The second base layer is divided into multiple base layers. Each of the first trenches contains a trench gate electrode. An emitter layer is intermittently formed in the surface region of selected base layers positioned between the first trenches, making contact with the trenches. Dummy trenches extend from the surface of the base region, where no emitter layer is formed, to the first base layer near each trench. A diffusion region is formed in the first base layer, in contact with the side of the dummy trenches at the bottom of each trench and at nearby positions.

Patent document 3 describes a semiconductor device that includes a semiconductor substrate of a first conductivity type, a first semiconductor layer of the first conductivity type, a second semiconductor layer of a second conductivity type, first semiconductor regions of the first conductivity type, second semiconductor regions of the second conductivity type, gate insulating films, gate electrodes, an insulating film, first electrodes, a second electrode, and trenches. The first semiconductor regions and second semiconductor regions are periodically arranged apart from one another along a first direction in which the trenches extend in a stripe pattern.

Patent document 4 concerns an insulated gate bipolar transistor comprising a semiconductor layer with a first surface and an opposing second surface. This semiconductor layer includes a P-type collector region, an N-type field stop layer, an N-type drift region, a P-type base region, and an emitter region, all sequentially stacked from the second surface toward the first surface. The emitter region consists of a P-type emitter region and an N-type emitter region. A plurality of grooves extend in the thickness direction of the semiconductor layer. The device also includes a current guide region and a current expansion region, where a P-type doped region and an N-type doped region are separated by grooves between the P-type doped region and the P-type base region, positioned around the bottom part of the grooves within the current expansion region.

Patent document 5 relates to a power semiconductor device that includes an active cell region with a drift region of a first conductivity type and a plurality of IGBT cells arranged within this active cell region. Each IGBT cell contains at least one trench extending into the drift region. The device also includes an edge termination region surrounding the active cell region and a transition region located between the active cell region and the edge termination region. Some of the IGBT cells are arranged within or extend into the transition region. A barrier region of a second conductivity type is positioned within the active cell region, in contact with certain trenches of the IGBT cells, and does not extend into the transition region. The power semiconductor device also includes a first load terminal and a second load terminal and is configured to conduct a load current along a vertical direction.
Patent Document 1: Japanese Patent Application Publication No. 2019-91892
Patent Document 2: US 2004/178441 A1
Patent Document 3: US 2021/296487 A1
Patent Document 4: CN 113054012 A
Patent Document 5: US 2021/043759 A1

### TECHNICAL PROBLEM

It is preferable that a breakdown voltage or a withstand capability of a semiconductor device does not decrease.

### GENERAL DISCLOSURE

The present invention is defined by the appended claims. In the following, parts of the description and drawings referring to former embodiments which do not necessarily comprise all features to implement embodiments of the claimed invention are understood to not represent embodiments of the invention but to relate to examples useful for understanding the embodiments of the invention. In order to solve the problem described above, a first aspect of the present invention provides a semiconductor device. The semiconductor device has an upper surface and a lower surface, and may include a semiconductor substrate including a drift region of a first conductivity type. The semiconductor device includes a gate runner including an outer circumferential gate runner and an active-side gate runner. Therein, the outer circumferential gate runner is arranged between the active portion and the end side of the semiconductor substrate in top view, the active-side gate runner is provided in the active portion, and the edge termination structure portion is arranged between the outer circumferential gate runner and the end side. The semiconductor device further includes a base region of a second conductivity type provided between the drift region and the upper surface of the semiconductor substrate. The semiconductor device includes a plurality of trench portions that are provided from the upper surface of the semiconductor substrate to below the base region and include a gate trench portion and a dummy trench portion. The semiconductor device includes a first lower end region of the second conductivity type that is provided to be in contact with lower ends of two or more trench portions which include the gate trench portion. The semiconductor device includes a well region of the second conductivity type that is provided below the gate runner from the upper surface of the semiconductor substrate to below the base region, wherein the well region has a higher doping concentration than the base region. The semiconductor device includes a separation region that is not overlapped with the first lower end region in a top view. In the semiconductor device, the separation region has a second lower end region of the second conductivity type that is provided to be in contact with lower ends of one or more trench portions including the gate trench portion.

In any of the semiconductor devices described above, the number of the trench portions in contact with one of second lower end regions, each being identical to the second lower end region, may be less than the number of the trench portions in contact with one of first lower end regions, each being identical to the first lower end region.

In any of the semiconductor devices described above, one of second lower end regions, each being identical to the second lower end region, is in contact with a lower end of one of gate trench portions, each being identical to the gate trench portion, and may not be in contact with a lower end of the gate trench portion other than that of the one of the gate trench portions.

Any of the semiconductor devices described above, one of first lower end regions, each being identical to the first lower end region, may be in contact with lower ends of a plurality of gate trench portions, each being identical to the gate trench portion, and a plurality of dummy trench portions, each being identical to the dummy trench portions.

In any of the semiconductor devices described above, one of second lower end regions, each being identical to the second lower end region, is in contact with a lower end of one of gate trench portions, each being identical to the gate trench portion, and may not be in contact with a lower end of the trench portion that is arranged adjacent to the gate trench portion.

In any of the semiconductor devices described above, one of second lower end regions, each being identical to the second lower end region, is in contact with a lower end of one of gate trench portions, each being identical to the gate trench portion, and may be in contact with a lower end of the dummy trench portion that is arranged adjacent to the gate trench portion.

Any of the semiconductor devices described above may include a third lower end region of a second conductivity type that is provided to be in contact with the lower end of the dummy trench portion. In any of the semiconductor devices described above, the dummy trench portion with which the third lower end region is in contact may be arranged adjacent to the gate trench portion with which the second lower end region is in contact. In any of the semiconductor devices described above, the third lower end region may be separated from all of the first lower end region, the second lower end region and the well region.

In any of the semiconductor devices described above, a plurality of second lower end regions, each being identical to the second lower end region, is arranged apart from each other along a longitudinal direction of the gate trench portion.

Any of the semiconductor devices described above may have the separation region being sandwiched by two of first lower end regions, each being identical to the first lower end region, in a top view.

In any of the semiconductor devices described above, the gate trench portion may have a gate dielectric film, and a gate conductive portion that is insulated from the semiconductor substrate by the gate dielectric film. In any of the semiconductor devices described above, the gate conductive portion at at least one among the gate trench portions in contact with the second lower end region may be shorter than the gate conductive portion of the gate trench portion in contact with the first lower end region in a depth direction.

In any of the semiconductor devices described above, two or more of the dummy trench portions that are not in contact with the first lower end region and the second lower end region may be arranged in series adjacent to the gate trench portion that is in contact with the first lower end region. Any of the semiconductor devices described above may include a fourth lower end region of the second conductivity type that is provided to be in contact with the lower ends of the two or more of the dummy trench portions arranged in series.

In any of the semiconductor devices described above, the gate trench portion may have a gate dielectric film, and a gate conductive portion that is insulated from the semiconductor substrate by the gate dielectric film. In any of the semiconductor devices described above, at at least one of the gate trench portions in contact with the second lower end region, the gate conductive portion at a position in contact with the gate dielectric film may be longer than the gate conductive portion at a position that is the farthest from the gate dielectric film in a depth direction.

In any of the semiconductor devices described above, at least one of the gate trench portions in contact with the second lower end region may be shorter than the gate trench portion in contact with the first lower end region in a depth direction.

In any of the semiconductor devices described above, at least one of first lower end regions, each being identical to the first lower end region, may be provided to be in contact with the lower end of the dummy trench portion. In any of the semiconductor devices described above, the separation region may include one or more of the dummy trench portions. In any of the semiconductor devices described above, at least one of the dummy trench portions of the separation region may be longer than the dummy trench portion in contact with the first lower end region in a depth direction.

Any of the semiconductor devices described above may include an emitter region of the first conductivity type that is exposed on the upper surface of the semiconductor substrate, is provided to be in contact with the gate trench portion, and has a doping concentration higher than that of the drift region. Any of the semiconductor devices described above may include a contact region of the second conductivity type that is exposed on the upper surface of the semiconductor substrate, is alternately arranged with the emitter region along a longitudinal direction of the gate trench portion, and has a doping concentration higher than that of the base region. In any of the semiconductor devices described above, the second lower end region may be arranged to overlap with the emitter region in a top view.

Any of the semiconductor devices described above may include a collector region of the second conductivity type that is provided to be in contact with the lower surface of the semiconductor substrate.

Any of the semiconductor devices described above may include a source region of the first conductivity type that is exposed on the upper surface of the semiconductor substrate, is provided to be in contact with the gate trench portion, and has a doping concentration higher than that of the drift region. Any of the semiconductor devices described above may include a contact region of the second conductivity type that is exposed on the upper surface of the semiconductor substrate, is alternately arranged with the source region along a longitudinal direction of the gate trench portion, and has a doping concentration higher than that of the base region. In any of the semiconductor devices described above, the second lower end region may be arranged to overlap with the source region in a top view.

Any of the semiconductor devices described above may include a drain region of the first conductivity type that is provided to be in contact with the lower surface of the semiconductor substrate.

In any of the semiconductor devices described above, for each of two or more of the gate trench portions, the second lower end region being separated from each other may be provided.

A example that is not encompassed by the claims but useful for understanding the invention provides a semiconductor device. The semiconductor device has an upper surface and a lower surface, and may include a semiconductor substrate including a drift region of the first conductivity type. Any of the semiconductor devices described above may include a base region of the second conductivity type provided between the drift region and the upper surface of the semiconductor substrate. Any of the semiconductor devices described above may include a plurality of trench portions that are provided from the upper surface of the semiconductor substrate to below the base region and include a gate trench portion and a dummy trench portion. Any of the semiconductor devices described above may include a second lower end region of the second conductivity type that is provided to be in contact with lower ends of one or more trench portions which include the gate trench portion. In any of the semiconductor devices described above, the gate trench portion in contact with the second lower end region may be shorter than at least another one of gate trench portions, each being identical to the gate trench portion, in a depth direction.

The summary clause does not necessarily describe all necessary features of the embodiments of the present invention. The present invention may also be a sub-combination of the features described above.

### BRIEF DESCRIPTION OF THE DRAWINGS

Fig. 1 illustrates a top view showing an example of a semiconductor device 100 according to one embodiment of the present invention.
Fig. 2 is an enlarged drawing of a region D in FIG. 1.
Fig. 3 shows an example of the cross section e-e in FIG. 2.
Fig. 4 shows an exemplary arrangement of a well region 11 and a first lower end region 202 in a top view.
Fig. 5 shows an example of the cross section f-f in Fig. 4.
Fig. 6 shows another array example of the gate trench portion 40 and the dummy trench portion 30.
Fig. 7 shows a distribution example of an electric field at a depth position of the lower end of the trench portion in an X axis direction.
Fig. 8 shows another example of the second lower end region 205.
Fig. 9A shows an enlarged drawing of a region near the first lower end region 202 and the second lower end region 205.
Fig. 9B shows an example of the formation process in Fig. 9A.
Fig. 10 shows another configuration example of the separation region 204.
Fig. 11 shows doping concentration distribution examples of the first lower end region 202, the second lower end region 205 and the third lower end region 207 in a Z axis direction.
Fig. 12 shows another example of the separation region 204.
Fig. 13 shows another example of the separation region 204.
Fig. 14 shows an example of the cross section g-g in Fig. 4.
Fig. 15 shows an example of the cross section h-h in Fig. 5, useful for understanding the present invention.
Fig. 16 shows an example of the cross section h-h in Fig. 5, according to the present invention.
Fig. 17 shows a partial process of a manufacturing method of the semiconductor device 100.
Fig. 18 illustrates an example of a lower end region forming step S1704.
Fig. 19 shows an example of a cross section j-j in FIG. 4.
Fig. 20 shows another example of the cross section f-f.
Fig. 21 shows another structural example of the separation region 204.
Fig. 22 shows another structural example of the separation region 204.
Fig. 23 shows another structural example of the separation region 204.
Fig. 24 shows another structural example of the separation region 204.

### DESCRIPTION OF EXEMPLARY EMBODIMENTS

Hereinafter, the present invention will be described through embodiments of the invention, but the following embodiments do not limit the invention according to claims. In addition, not all of the combinations of features described in the embodiments are essential to the solution of the invention.

As used herein, one side in a direction parallel to a depth direction of a semiconductor substrate is referred to as "upper" and the other side is referred to as "lower". One surface of two principal surfaces of a substrate, a layer or other member is referred to as an upper surface, and the other surface is referred to as a lower surface. "Upper" and "lower" directions are not limited to a direction of gravity, or a direction in which a semiconductor device is mounted.

In the present specification, technical matters may be described using orthogonal coordinate axes of an X axis, a Y axis, and a Z axis. The orthogonal coordinate axes merely specify relative positions of components, and do not limit a specific direction. For example, the Z axis is not limited to indicate a height direction with respect to the ground. Note that a +Z axis direction and a -Z axis direction are directions opposite to each other. When the Z axis direction is described without describing the signs, it means that the direction is parallel to the +Z axis and the -Z axis.

In the present specification, orthogonal axes parallel to the upper surface and the lower surface of the semiconductor substrate are referred to as the X axis and the Y axis. Further, an axis perpendicular to the upper surface and the lower surface of the semiconductor substrate is referred to as the Z axis. In the present specification, the direction of the Z axis may be referred to as the depth direction. Further, in the present specification, a direction parallel to the upper surface and the lower surface of the semiconductor substrate may be referred to as a horizontal direction, including an X axis direction and a Y axis direction.

In addition, a region from the center of the semiconductor substrate in the depth direction to the upper surface of the semiconductor substrate may be referred to as an upper surface side. Similarly, a region from the center of the semiconductor substrate in the depth direction to the lower surface of the semiconductor substrate may be referred to as a lower surface side.

In the present specification, a case where a term such as "same" or "equal" is mentioned may include a case where an error due to a variation in manufacturing or the like is included. The error is, for example, within 10%.

In the present specification, a conductivity type of a doping region where doping has been carried out with an impurity is described as a P type or an N type. In the present specification, the impurity may particularly mean either a donor of the N type or an acceptor of the P type, and may be described as a dopant. In the present specification, doping means introducing the donor or the acceptor into the semiconductor substrate and turning it into a semiconductor presenting a conductivity type of the N type, or a semiconductor presenting a conductivity type of the P type.

In the present specification, a doping concentration means a concentration of the donor or a concentration of the acceptor in a thermal equilibrium state. In the present specification, a net doping concentration means a net concentration obtained by adding the donor concentration set as a positive ion concentration to the acceptor concentration set as a negative ion concentration, taking into account of polarities of charges. As an example, when the donor concentration is N_{D} and the acceptor concentration is N_{A}, the net doping concentration at any position is given as N_{D} - N_{A}. In the present specification, the net doping concentration may be simply referred to as the doping concentration.

The donor has a function of supplying electrons to a semiconductor. The acceptor has a function of receiving electrons from the semiconductor. The donor and the acceptor are not limited to the impurities themselves. For example, a VOH defect which is a combination of a vacancy (V), oxygen (O), and hydrogen (H) existing in the semiconductor functions as the donor that supplies electrons. In the present specification, the VOH defect may be referred to as a hydrogen donor.

In the semiconductor substrate of the present specification, bulk donors of the N type are distributed throughout. The bulk donor is a dopant donor substantially uniformly contained in an ingot during the manufacture of the ingot from which the semiconductor substrate is made. The bulk donor of this example is an element other than hydrogen. The dopant of the bulk donor is, for example, phosphorous, antimony, arsenic, selenium, or sulfur, but the present invention is not limited to these. The bulk donor of this example is phosphorous. The bulk donor is also contained in a region of the P type. The semiconductor substrate may be a wafer cut out from a semiconductor ingot, or may be a chip obtained by singulating the wafer. The semiconductor ingot may be manufactured by any one of a Czochralski method (CZ method), a magnetic field applied Czochralski method (MCZ method), or a float zone method (FZ method). The ingot of this example is manufactured by the MCZ method. An oxygen concentration contained in the substrate manufactured by the MCZ method is 1×10¹⁷ to 7x10¹⁷/cm³. The oxygen concentration contained in the substrate manufactured by the FZ method is 1×10¹⁵ to 5×10¹⁶/cm³. When the oxygen concentration is high, hydrogen donors tend to be easily generated. The bulk donor concentration may use a chemical concentration of bulk donors distributed throughout the semiconductor substrate, or may be a value from 90% to 100% of the chemical concentration. In addition, as the semiconductor substrate, a non-doped substrate not containing a dopant such as phosphorous may be used. In that case, the bulk donor concentration (DO) of the non-doped substrate is, for example, from 1×10¹⁰/cm³ or more and to 5×10¹²/cm³ or less. The bulk donor concentration (DO) of the non-doped substrate is preferably 1×10¹¹/cm³ or more. The bulk donor concentration (DO) of the non-doped substrate is preferably 5×10¹²/cm³ or less. Each concentration in the present invention may be a value at room temperature. As the value at room temperature, a value at 300 K (Kelvin) (about 26.9°C) may be used as an example.

In the present specification, a description of a P+ type or an N+ type means a higher doping concentration than that of the P type or the N type, and a description of a P- type or an N-type means a lower doping concentration than that of the P type or the N type. Further, in the specification, a description of a P++ type or an N++ type means a higher doping concentration than that of the P+ type or the N+ type. In the specification, a unit system is the SI base unit system unless otherwise particularly noted. Although a unit of length may be expressed in cm, calculations may be carried out after conversion to meters (m).

A chemical concentration in the present specification indicates an atomic density of an impurity measured regardless of an electrical activation state. The chemical concentration can be measured by, for example, secondary ion mass spectrometry (SIMS). The net doping concentration described above can be measured by capacitance-voltage profiling (CV profiling). Further, a carrier concentration measured by spreading resistance profiling (SRP method) may be set as the net doping concentration. The carrier concentration measured by the CV profiling or the SRP method may be a value in a thermal equilibrium state. Further, in a region of an N type, the donor concentration is sufficiently higher than the acceptor concentration, and thus the carrier concentration of the region may be set as the donor concentration. Similarly, in a region of a P type, the carrier concentration of the region may be set as the acceptor concentration. In the present specification, the doping concentration of the N type region may be referred to as the donor concentration, and the doping concentration of the P type region may be referred to as the acceptor concentration.

Further, when a concentration distribution of the donor, acceptor, or net doping has a peak in a region, a value of the peak may be set as the concentration of the donor, acceptor, or net doping in the region. In a case where the concentration of the donor, acceptor or net doping is substantially uniform in a region, or the like, an average value of the concentration of the donor, acceptor or net doping in the region may be set as the concentration of the donor, acceptor or net doping. In the present specification, atoms/cm³ or /cm³ is used to indicate a concentration per unit volume. This unit is used for a concentration of a donor or an acceptor in a semiconductor substrate, or a chemical concentration. A notation of atoms may be omitted.

The carrier concentration measured by the SRP method may be lower than the concentration of the donor or the acceptor. In a range where a current flows when a spreading resistance is measured, carrier mobility of the semiconductor substrate may be lower than a value in a crystalline state. The reduction in carrier mobility occurs when carriers are scattered due to disorder (disorder) of a crystal structure due to a lattice defect or the like.

The concentration of the donor or the acceptor calculated from the carrier concentration measured by the CV profiling or the SRP method may be lower than a chemical concentration of an element indicating the donor or the acceptor. As an example, in a silicon semiconductor, a donor concentration of phosphorous or arsenic serving as a donor, or an acceptor concentration of boron (boron) serving as an acceptor is approximately 99% of chemical concentrations of these. On the other hand, in the silicon semiconductor, a donor concentration of hydrogen serving as a donor is approximately from 0.1% to 10% of a chemical concentration of hydrogen.

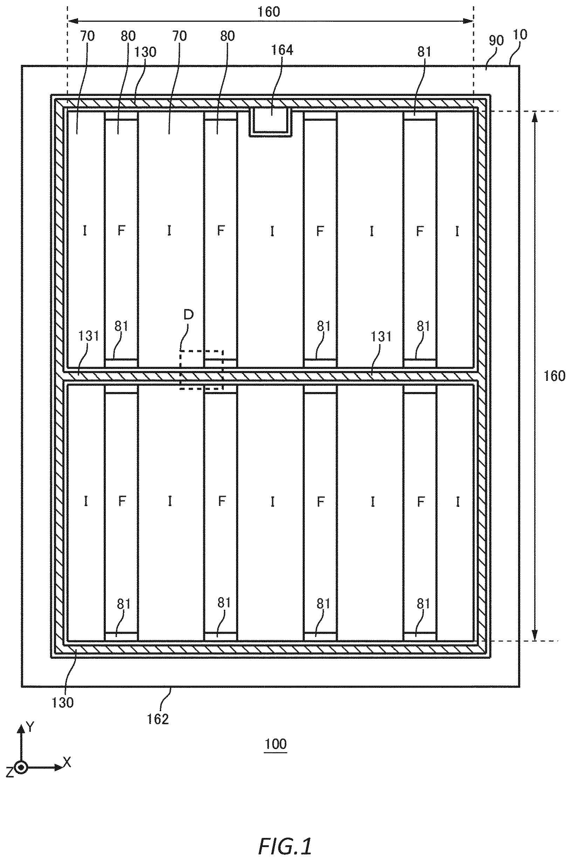

Fig. 1 illustrates a top view showing an example of a semiconductor device 100 according to one embodiment of the present invention. Fig. 1 shows a position at which each member is projected on an upper surface of a semiconductor substrate 10. Fig. 1 shows merely some members of the semiconductor device 100, and omits illustrations of some members.

The semiconductor device 100 includes the semiconductor substrate 10. The semiconductor substrate 10 is a substrate that is formed of a semiconductor material. As an example, the semiconductor substrate 10 is a silicon substrate. The semiconductor substrate 10 has an end side 162 in the top view. When merely referred to as the top view in the present specification, it means that the semiconductor substrate 10 is viewed from an upper surface side. The semiconductor substrate 10 of this example has two sets of end sides 162 facing each other in a top view. In Fig. 1, the X axis and the Y axis are parallel to any of the end sides 162. In addition, the Z axis is perpendicular to the upper surface of the semiconductor substrate 10.

The semiconductor substrate 10 is provided with an active portion 160. The active portion 160 is a region where a main current flows in the depth direction between the upper surface and a lower surface of the semiconductor substrate 10 when the semiconductor device 100 operates. An emitter electrode is provided above the active portion 160, but is omitted in Fig. 1. The active portion 160 may refer to a region that overlaps with the emitter electrode in the top view. In addition, a region sandwiched by the active portion 160 in the top view may also be included in the active portion 160.

The active portion 160 is provided with a transistor portion 70 including a transistor element such as an IGBT (Insulated Gate Bipolar Transistor). The active portion 160 may further be provided with a diode portion 80 including a diode element such as a freewheeling diode (FWD). In the example of Fig. 1, the transistor portion 70 and the diode portion 80 are alternately arranged along a predetermined array direction (the X axis direction in this example) on the upper surface of the semiconductor substrate 10. The semiconductor device 100 of this example is a reverse-conducting IGBT (RC-IGBT).

In Fig. 1, a region where each of the transistor portions 70 is arranged is indicated by a symbol "I", and a region where each of the diode portions 80 is arranged is indicated by a symbol "F". In the present specification, a direction perpendicular to the array direction in a top view may be referred to as an extending direction (the Y axis direction in Fig. 1). Each of the transistor portions 70 and the diode portions 80 may have a longitudinal length in the extending direction. In other words, the length of each of the transistor portions 70 in the Y axis direction is greater than the width in the X axis direction. Similarly, the length of each of the diode portions 80 in the Y axis direction is greater than the width in the X axis direction. The extending direction of the transistor portion 70 and the diode portion 80, and a longitudinal direction of each trench portion which will be described below may be the same.

Each of the diode portions 80 includes a cathode region of N+ type in a region in contact with the lower surface of the semiconductor substrate 10. In the present specification, a region where the cathode region is provided is referred to as the diode portion 80. In other words, the diode portion 80 is a region that overlaps with the cathode region in the top view. On the lower surface of the semiconductor substrate 10, a collector region of the P+ type may be provided in a region other than the cathode region. In the present specification, the diode portion 80 may also include an extension region 81 where the diode portion 80 extends to a gate runner to be described later in the Y axis direction. The collector region is provided on a lower surface of the extension region 81.

The transistor portion 70 has the collector region of the P+ type in a region in contact with the lower surface of the semiconductor substrate 10. Further, in the transistor portion 70, an emitter region of the N type, a base region of the P type, and a gate structure having a gate conductive portion and a gate dielectric film are periodically arranged on the upper surface side of the semiconductor substrate 10.

The semiconductor device 100 may have one or more pads above the semiconductor substrate 10. The semiconductor device 100 of this example has a gate pad 164. The semiconductor device 100 may have a pad such as an anode pad, a cathode pad, and a current detection pad. Each pad is arranged in a region close to the end side 162. The region close to the end side 162 refers to a region between the end side 162 and the emitter electrode in the top view. When the semiconductor device 100 is mounted, each pad may be connected to an external circuit via a wiring such as a wire.

A gate potential is applied to the gate pad 164. The gate pad 164 is electrically connected to a conductive portion of a gate trench portion of the active portion 160. The semiconductor device 100 includes a gate runner that connects the gate pad 164 and the gate trench portion. In Fig. 1, the gate runner is hatched with diagonal lines.

The gate runner of the present example includes an outer circumferential gate runner 130 and an active-side gate runner 131. The outer circumferential gate runner 130 is arranged between the active portion 160 and the end side 162 of the semiconductor substrate 10 in the top view. The outer circumferential gate runner 130 of the present example encloses the active portion 160 in the top view. A region enclosed by the outer circumferential gate runner 130 in the top view may be the active portion 160. In addition, a well region is formed below the gate runner. The well region is a region of the P type having a higher concentration than the base region described below, and is formed to a position deeper than the base region from the upper surface of the semiconductor substrate 10. A region surrounded by the well region in the top view may be the active portion 160.

The outer circumferential gate runner 130 is connected to the gate pad 164. The outer circumferential gate runner 130 is arranged above the semiconductor substrate 10. The outer circumferential gate runner 130 may be a metal wiring containing aluminum or the like.

The active-side gate runner 131 is provided in the active portion 160. Providing the active-side gate runner 131 in the active portion 160 can reduce a variation in wiring length from the gate pad 164 for each region of the semiconductor substrate 10.

The outer circumferential gate runner 130 and the active-side gate runner 131 are connected to the gate trench portion of the active portion 160. The outer circumferential gate runner 130 and the active-side gate runner 131 are arranged above the semiconductor substrate 10. The outer circumferential gate runner 130 and the active-side gate runner 131 may be a wiring formed of a semiconductor such as polysilicon doped with an impurity.

The active-side gate runner 131 may be connected to the outer circumferential gate runner 130. The active-side gate runner 131 of this example is provided extending in the X axis direction so as to cross the active portion 160 from one outer circumferential gate runner 130 to the other outer circumferential gate runner 130 sandwiching the active portion 160, substantially at the center of the Y axis direction. When the active portion 160 is divided by the active-side gate runner 131, the transistor portion 70 and the diode portion 80 may be alternately arranged in the X axis direction in each of the divided regions.

In addition, the semiconductor device 100 may include a temperature sensing portion (not shown) which is a PN junction diode formed of polysilicon or the like, and a current detection portion (not shown) which simulates an operation of the transistor portion provided in the active portion 160.

The semiconductor device 100 of this example includes an edge termination structure portion 90 between the active portion 160 and the end side 162 in the top view. The edge termination structure portion 90 of this example is arranged between the outer circumferential gate runner 130 and the end side 162. The edge termination structure portion 90 reduces an electric field strength on the upper surface side of the semiconductor substrate 10. The edge termination structure portion 90 may include at least one of a guard ring, a field plate, or a RESURF annularly provided to enclose the active portion 160.

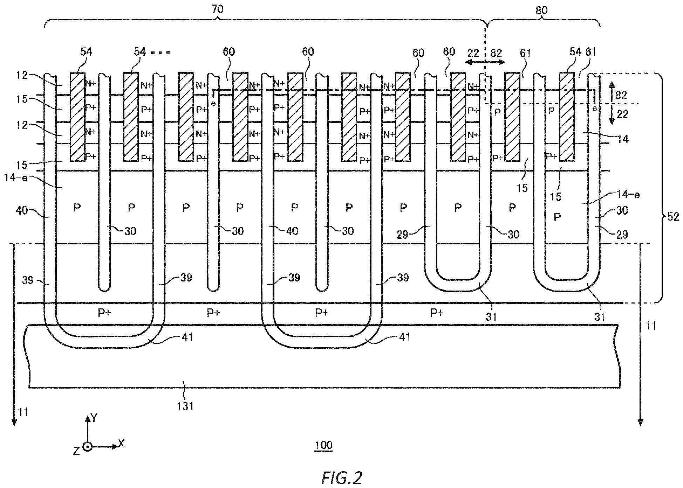

FIG. 2 is an enlarged drawing of a region D in FIG. 1. The region D is a region including the transistor portion 70, the diode portion 80, and the active-side gate runner 131. The semiconductor device 100 of this example includes a gate trench portion 40, a dummy trench portion 30, a well region 11, an emitter region 12, a base region 14, and a contact region 15 which are provided inside on the upper surface side of the semiconductor substrate 10. The gate trench portion 40 and the dummy trench portion 30 each are an example of the trench portion. In addition, the semiconductor device 100 of the present example includes an emitter electrode 52 and the active-side gate runner 131 which are provided above the upper surface of the semiconductor substrate 10. The emitter electrode 52 and the active-side gate runner 131 are provided separate from each other.

Between the emitter electrode 52 and the active-side gate runner 131, and the upper surface of the semiconductor substrate 10, an interlayer dielectric film is provided, but an illustration thereof is omitted in Fig. 2. In the interlayer dielectric film of this example, a contact hole 54 is provided passing through the interlayer dielectric film. In Fig. 2, each contact hole 54 is hatched with the diagonal lines.

The emitter electrode 52 is provided above the gate trench portion 40, the dummy trench portion 30, the well region 11, the emitter region 12, the base region 14, and the contact region 15. The emitter electrode 52 is in contact with the emitter region 12, the contact region 15, and the base region 14 on the upper surface of the semiconductor substrate 10, through the contact hole 54. Further, the emitter electrode 52 is connected to a dummy conductive portion in the dummy trench portion 30 through a contact hole provided in the interlayer dielectric film. The emitter electrode 52 may be connected to the dummy conductive portion of the dummy trench portion 30 at an edge of the dummy trench portion 30 in the Y axis direction. The dummy conductive portion of the dummy trench portion 30 may not be connected to the emitter electrode 52 and the gate conductive portion, and may be controlled to be set at a potential different from the potential of the emitter electrode 52 and the potential of the gate conductive portion.

The active-side gate runner 131 is connected to the gate trench portion 40 through the contact hole provided in the interlayer dielectric film. The active-side gate runner 131 may be connected to a gate conductive portion of the gate trench portion 40 in an edge portion 41 of the gate trench portion 40 in the Y axis direction. The active-side gate runner 131 is not connected to the dummy conductive portion in the dummy trench portion 30.

The emitter electrode 52 is formed of a material including metal. Fig. 2 shows a range where the emitter electrode 52 is provided. For example, at least a part of a region of the emitter electrode 52 is formed of aluminum or an aluminum-silicon alloy, for example, a metal alloy such as AlSi or AlSiCu. The emitter electrode 52 may have a barrier metal formed of titanium, a titanium compound, or the like below a region formed of aluminum or the like. Further, a plug, which is formed by embedding tungsten or the like so as to be in contact with the barrier metal and aluminum or the like, may be included in the contact hole.

The well region 11 is provided so as to overlap with the active-side gate runner 131. The well region 11 is provided so as to extend with a predetermined width also in a range not overlapping with the active-side gate runner 131. The well region 11 of this example is provided away from an end of the contact hole 54 in the Y axis direction toward the active-side gate runner 131 side. The well region 11 is a second conductivity type region having a higher doping concentration than the base region 14. The base region 14 of the present example is of the P-type, and the well region 11 is of the P+ type.

Each of the transistor portion 70 and the diode portion 80 includes a plurality of trench portions arranged in the array direction. In the transistor portion 70 of this example, one or more gate trench portions 40 and one or more dummy trench portions 30 are alternately provided along the array direction. In the diode portion 80 of the present example, the plurality of dummy trench portions 30 are provided along the array direction. In the diode portion 80 of this example, the gate trench portion 40 is not provided.

The gate trench portion 40 of the present example may have two linear portions 39 extending along the extending direction perpendicular to the array direction (portions of a trench that are linear along the extending direction), and the edge portion 41 connecting the two linear portions 39. The extending direction in Fig. 2 is the Y axis direction.

At least a part of the edge portion 41 is preferably provided in a curved shape in a top view. By connecting between end portions of the two linear portions 39 in the Y axis direction by the edge portion 41, it is possible to reduce the electric field strength at the end portions of the linear portions 39.

In the transistor portion 70, the dummy trench portions 30 are provided between the respective linear portions 39 of the gate trench portions 40. Between the respective linear portions 39, one dummy trench portion 30 may be provided, or a plurality of dummy trench portions 30 may be provided. The dummy trench portion 30 may have a linear shape extending in the extending direction, or may have linear portions 29 and an edge portion 31 similar to the gate trench portion 40. The semiconductor device 100 shown in Fig. 2 includes both of the linear dummy trench portion 30 having no edge portion 31, and the dummy trench portion 30 having the edge portion 31.

A diffusion depth of the well region 11 may be deeper than the depth of the gate trench portion 40 and the dummy trench portion 30. The end portions in the Y axis direction of the gate trench portion 40 and the dummy trench portion 30 are provided in the well region 11 in a top view. In other words, the bottom of each trench portion in the depth direction is covered with the well region 11 at the end portion of each trench portion in the Y axis direction. With this configuration, the electric field strength on the bottom portion of each trench portion can be reduced.

A mesa portion is provided between the respective trench portions in the array direction. The mesa portion refers to a region sandwiched between the trench portions inside the semiconductor substrate 10. As an example, an upper end of the mesa portion is the upper surface of the semiconductor substrate 10. The depth position of the lower end of the mesa portion is the same as the depth position of the lower end of the trench portion. The mesa portion of the present example is provided so as to extend in the extending direction (the Y axis direction) along the trench, on the upper surface of the semiconductor substrate 10. In the present example, a mesa portion 60 is provided in the transistor portion 70, and a mesa portion 61 is provided in the diode portion 80. In the case of simply mentioning "mesa portion" in the present specification, the portion refers to each of the mesa portion 60 and the mesa portion 61.

Each mesa portion is provided with the base region 14. In the mesa portion, a region arranged closest to the active-side gate runner 131, in the base region 14 exposed on the upper surface of the semiconductor substrate 10, is to be a base region 14-e. While Fig. 2 shows the base region 14-e arranged at one end portion of each mesa portion in the extending direction, the base region 14-e is also arranged at the other end portion of each mesa portion. In each mesa portion, at least one of the emitter region 12 of the first conductivity type or the contact region 15 of the second conductivity type may be provided in the region sandwiched between the base regions 14-e in a top view. The emitter region 12 of this example is an N+ type, and the contact region 15 is a P+ type. The emitter region 12 and the contact region 15 may be provided between the base region 14 and the upper surface of the semiconductor substrate 10 in the depth direction.

The mesa portion 60 of the transistor portion 70 includes the emitter region 12 exposed on the upper surface of the semiconductor substrate 10. The emitter region 12 is provided in contact with the gate trench portion 40. The mesa portion 60 in contact with the gate trench portion 40 may be provided with the contact region 15 exposed on the upper surface of the semiconductor substrate 10.

Each of the contact region 15 and the emitter region 12 in the mesa portion 60 is provided from one trench portion to the other trench portion in the X axis direction. As an example, the contact region 15 and the emitter region 12 of the mesa portion 60 are alternately arranged along the extending direction of the trench portion (the Y axis direction).

In another example, the contact region 15 and the emitter region 12 of the mesa portion 60 may be provided in a stripe pattern along the extending direction of the trench portion (the Y axis direction). For example, the emitter region 12 is provided in a region in contact with the trench portion, and the contact region 15 is provided in a region sandwiched between the emitter regions 12.

The emitter region 12 is not provided in the mesa portion 61 of the diode portion 80. The base region 14 and the contact region 15 may be provided on an upper surface of the mesa portion 61. The contact region 15 may be provided in contact with each of the base regions 14-e in a region sandwiched between the base regions 14-e on the upper surface of the mesa portion 61. The base region 14 may be provided in a region sandwiched between the contact regions 15 on the upper surface of the mesa portion 61. The base region 14 may be arranged in the entire region sandwiched between the contact regions 15.

The contact hole 54 is provided above each mesa portion. The contact hole 54 is arranged in the region sandwiched between the base regions 14-e. The contact hole 54 of this example is provided above respective regions of the contact region 15, the base region 14, and the emitter region 12. The contact hole 54 is not provided in regions corresponding to the base region 14-e and the well region 11. The contact hole 54 may be arranged at the center of the mesa portion 60 in the array direction (the X axis direction).

In the diode portion 80, a cathode region 82 of the N+ type is provided in a region in direct contact with the lower surface of the semiconductor substrate 10. On the lower surface of the semiconductor substrate 10, a collector region 22 of the P+ type may be provided in a region where the cathode region 82 is not provided. The cathode region 82 and the collector region 22 are provided between the lower surface 23 of the semiconductor substrate 10 and a buffer region 20. In Fig. 2, a boundary between the cathode region 82 and the collector region 22 is indicated by a dotted line.

The cathode region 82 is arranged apart from the well region 11 in the Y axis direction. With this configuration, a distance between the P type region (the well region 11) which has a relatively high doping concentration and is formed to a deep position and the cathode region 82 is ensured, so that the breakdown voltage can be improved. The end portion in the Y axis direction of the cathode region 82 of this example is arranged farther away from the well region 11 than the end portion in the Y axis direction of the contact hole 54. In another example, the end portion in the Y axis direction of the cathode region 82 may be arranged between the well region 11 and the contact hole 54.

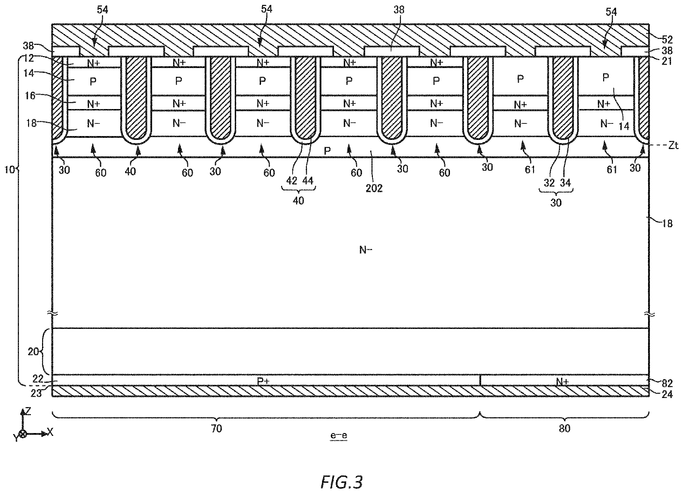

FIG. 3 is a drawing showing an example of a cross section e-e in FIG. 2. The cross section e-e is an XZ plane passing through the emitter region 12 and the cathode region 82. The semiconductor device 100 of this example includes the semiconductor substrate 10, the interlayer dielectric film 38, the emitter electrode 52, and the collector electrode 24 in the cross section.

The interlayer dielectric film 38 is provided on the upper surface of the semiconductor substrate 10. The interlayer dielectric film 38 is a film including at least one layer of a dielectric film such as silicate glass to which an impurity such as boron or phosphorous is added, a thermal oxide film, and other dielectric films. The interlayer dielectric film 38 is provided with the contact hole 54 described in Fig. 2.

The emitter electrode 52 is provided on the upper side of the interlayer dielectric film 38. The emitter electrode 52 is in contact with an upper surface 21 of the semiconductor substrate 10 through the contact hole 54 of the interlayer dielectric film 38. The collector electrode 24 is provided on a lower surface 23 of the semiconductor substrate 10. The emitter electrode 52 and the collector electrode 24 are formed of a metal material such as aluminum. In the specification, the direction in which the emitter electrode 52 is connected to the collector electrode 24 (the z axis direction) is referred to as a depth direction.

The semiconductor substrate 10 includes an N type or N- type drift region 18. The drift region 18 is provided in each of the transistor portion 70 and the diode portion 80.

In the mesa portion 60 of the transistor portion 70, an N+ type of emitter region 12 and a P-type of base region 14 are provided in order from an upper surface 21 side of the semiconductor substrate 10. The drift region 18 is provided below the base region 14. The mesa portion 60 may be provided with an N+ type accumulation region 16. The accumulation region 16 is arranged between the base region 14 and the drift region 18.

The emitter region 12 is exposed on the upper surface 21 of the semiconductor substrate 10 and is provided in contact with the gate trench portion 40. The emitter region 12 may be in contact with the trench portions on both sides of the mesa portion 60. The emitter region 12 has a higher doping concentration than the drift region 18.

The base region 14 is provided below the emitter region 12. The base region 14 of this example is provided in contact with the emitter region 12. The base region 14 may be in contact with the trench portions on both sides of the mesa portion 60.

The accumulation region 16 is provided below the base region 14. The accumulation region 16 is an N+ type region having a higher doping concentration than the drift region 18. That is, the accumulation region 16 has a higher donor concentration than the drift region 18. By providing the accumulation region 16 having the high concentration between the drift region 18 and the base region 14, it is possible to improve a carrier injection enhancement effect (IE effect) and reduce an on-voltage. The accumulation region 16 may be provided to cover an entire lower surface of the base region 14 in each mesa portion 60.

The mesa portion 61 of the diode portion 80 is provided with the P- type of base region 14 in contact with the upper surface 21 of the semiconductor substrate 10. The drift region 18 is provided below the base region 14. In the mesa portion 61, the accumulation region 16 may be provided below the base region 14.

In each of the transistor portion 70 and the diode portion 80, an N+ type buffer region 20 may be provided below the drift region 18. The doping concentration of the buffer region 20 is higher than the doping concentration of the drift region 18. The buffer region 20 may have a concentration peak having a higher doping concentration than the drift region 18. The doping concentration of the concentration peak indicates a doping concentration at the local maximum of the concentration peak. Further, as the doping concentration of the drift region 18, an average value of doping concentrations in the region where the doping concentration distribution is substantially flat may be used.

The buffer region 20 may have two or more concentration peaks in the depth direction (Z axis direction) of the semiconductor substrate 10. The concentration peak of the buffer region 20 may be provided at the same depth position as, for example, a chemical concentration peak of hydrogen (a proton) or phosphorous. The buffer region 20 may function as a field stopper layer which prevents a depletion layer expanding from the lower end of the base region 14 from reaching the collector region 22 of the P+ type and the cathode region 82 of the N+ type.

In the transistor portion 70, the collector region 22 of the P+ type is provided below the buffer region 20. An acceptor concentration of the collector region 22 is higher than an acceptor concentration of the base region 14. The collector region 22 may include an acceptor which is the same as or different from an acceptor of the base region 14. The acceptor of the collector region 22 is, for example, boron.

Below the buffer region 20 in the diode portion 80, the cathode region 82 of the N+ type is provided. A donor concentration of the cathode region 82 is higher than a donor concentration of the drift region 18. A donor of the cathode region 82 is, for example, hydrogen or phosphorous. Note that an element serving as a donor and an acceptor in each region is not limited to the above-described example. The collector region 22 and the cathode region 82 are exposed on the lower surface 23 of the semiconductor substrate 10 and are connected to the collector electrode 24. The collector electrode 24 may be in contact with the entire lower surface 23 of the semiconductor substrate 10. The emitter electrode 52 and the collector electrode 24 are formed of a metal material such as aluminum.

One or more gate trench portions 40 and one or more dummy trench portions 30 are provided on the upper surface 21 side of the semiconductor substrate 10. Each trench portion passes through the base region 14 from the upper surface 21 of the semiconductor substrate 10, and is provided to below the base region 14. In a region where at least any one of the emitter region 12, the contact region 15, and the accumulation region 16 is provided, each trench portion also passes through the doping regions of these. The configuration of the trench portion penetrating through the doping region is not limited to that manufactured in the order of forming the doping region and then forming the trench portion. The configuration of the trench portion passing through the doping region includes a configuration of the doping region being formed between the trench portions after forming the trench portion.

As described above, the transistor portion 70 is provided with the gate trench portion 40 and the dummy trench portion 30. In the diode portion 80, the dummy trench portion 30 is provided, and the gate trench portion 40 is not provided. The boundary in the X axis direction between the diode portion 80 and the transistor portion 70 in this example is the boundary between the cathode region 82 and the collector region 22.

The gate trench portion 40 includes a gate trench provided in the upper surface 21 of the semiconductor substrate 10, a gate dielectric film 42, and a gate conductive portion 44. The gate dielectric film 42 is provided to cover the inner wall of the gate trench. The gate dielectric film 42 may be formed by oxidizing or nitriding a semiconductor on the inner wall of the gate trench. The gate conductive portion 44 is provided inside from the gate dielectric film 42 in the gate trench. That is, the gate dielectric film 42 insulates the gate conductive portion 44 from the semiconductor substrate 10. The gate conductive portion 44 is formed of a conductive material such as polysilicon.

The gate conductive portion 44 may be provided longer than the base region 14 in the depth direction. The gate trench portion 40 in the cross section is covered by the interlayer dielectric film 38 on the upper surface 21 of the semiconductor substrate 10. The gate conductive portion 44 is electrically connected to the gate runner. When a predetermined gate voltage is applied to the gate conductive portion 44, a channel is formed by an electron inversion layer in a surface layer of the base region 14 at a boundary in contact with the gate trench portion 40.

The dummy trench portions 30 may have the same structure as those of the gate trench portions 40 in the cross section. The dummy trench portion 30 includes a dummy trench provided in the upper surface 21 of the semiconductor substrate 10, a dummy dielectric film 32, and a dummy conductive portion 34. The dummy conductive portion 34 is electrically connected to the emitter electrode 52. The dummy dielectric film 32 is provided covering an inner wall of the dummy trench. The dummy conductive portion 34 is provided in the dummy trench, and is provided inside the dummy dielectric film 32. The dummy dielectric film 32 insulates the dummy conductive portion 34 from the semiconductor substrate 10. The dummy conductive portion 34 may be formed of the same material as that of the gate conductive portion 44. For example, the dummy conductive portion 34 is formed of a conductive material such as polysilicon or the like. The dummy conductive portion 34 may have the same length as that of the gate conductive portion 44 in the depth direction.

The gate trench portion 40 and the dummy trench portion 30 of this example are covered with the interlayer dielectric film 38 on the upper surface 21 of the semiconductor substrate 10. Note that the bottoms of the dummy trench portion 30 and the gate trench portion 40 may be formed in a curved-surface shape (a curved shape in the cross section) convexly downward. In the present specification, a depth position of a lower end of the gate trench portion 40 is set as Zt.

The semiconductor device 100 of the present example includes a P type first lower end region 202 which is provided to be in contact with the lower end of the trench portion. A doping concentration of the first lower end region 202 may be equal to or less than a doping concentration of the base region 14. A doping concentration of the first lower end region 202 of the present example is lower than a doping concentration of the base region 14. A P type dopant may be boron or may be aluminum.

The first lower end region 202 is arranged apart from the base region 14. An N type region (in the present example, at least one of the accumulation region 16 or the drift region 18) is provided between the first lower end region 202 and the base region 14.

The first lower end regions 202 are provided continuously to be in contact with the lower end of two or more trench portions in an X axis direction. That is, the first lower end region 202 is provided to cover a mesa portion between the trench portions. The first lower end region 202 may cover a plurality of mesa portions. The first lower end region 202 of the present example is provided to be in contact with the lower end of each of the two or more trench portions including the gate trench portion 40.

The first lower end region 202 may be in contact with the lower end of each of the two or more trench portions in the respective transistor portions 70. Also, the first lower end region 202 may be in contact with the lower end of each of the two or more gate trench portions 40 in the respective transistor portions 70. The first lower end region 202 may be in contact with the lower end of each of the two or more dummy trench portions 30 in the respective transistor portions 70. The first lower end region 202 may be in contact with the lower end of each of all the trench portions in at least one transistor portion 70. Also, the first lower end region 202 may be in contact with the lower end of each of all the gate trench portions 40 in at least one transistor portion 70.

The first lower end region 202 may be in contact with the lower end of each of the two or more trench portions in the respective diode portions 80. The first lower end region 202 may be in contact with the lower end of each of all the trench portions in at least one diode portion 80.

The first lower end region 202 is provided to extend in a Y axis direction. A length of the first lower end region 202 in the Y axis direction is shorter than a length of the trench portion in the Y axis direction. Also, the length of the first lower end region 202 in the Y axis direction may be 50% or more, may be 70% or more, may be 90% or more of the length of the trench portion in the Y axis direction.

By providing the first lower end region 202, a potential increase near the lower end of the trench portion when the semiconductor device 100 is turned on can be suppressed. Thus, it is possible to reduce a slope (dv/dt) of a waveform of emitter-collector voltage at the time of turn-on and to reduce noise in a voltage or current waveform at the time of switching.

Note that a potential of the first lower end region 202 is different from a potential of the emitter electrode 52. As described above, the first lower end region 202 is arranged, in a Z axis direction, apart from the base region 14 which is connected to the emitter electrode 52. Also, the first lower end region 202 is arranged, in a top view, apart from the well region which is connected to the emitter electrode 52. The active portion 160 may have a portion to which the first lower end region 202 is not provided in at least one of the X axis direction or the Y axis direction. The first lower end region 202 may be an electrically floating region to which no electrode is connected.

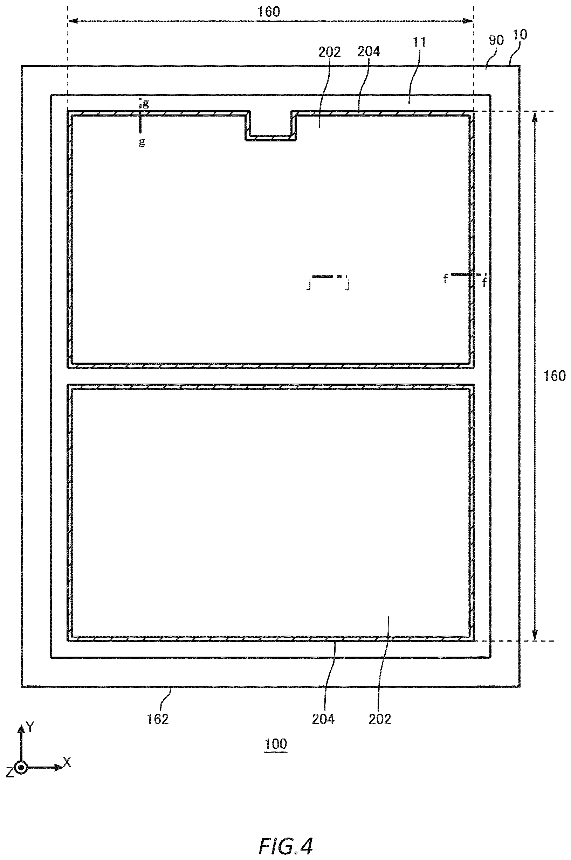

Fig. 4 shows an exemplary arrangement of a well region 11 and a first lower end region 202 in a top view. The first lower end region 202 of the present example is provided in the active portion 160. The first lower end region 202 may be provided in an area of 50% or more, may be provided in an area of 70% or more, or may be provided in an area of 90% or more of the active portion 160 in a top view.

The well region 11 is provided below the gate runner shown in the Fig. 1. In a top view, the well region 11 and the first lower end region 202 are arranged in different locations. As shown in Fig. 4, in a top view, the well region 11 may be arranged to surround the first lower end region 202. As shown in Fig. 4, when the first lower end region 202 is divided into a plurality of regions, the well region 11 may surround the respective first lower end regions 202.

In a top view, an separation region 204 is provided between the well region 11 and the first lower end region 202. The separation region 204 is not overlapped with the first lower end region 202 in a top view. The separation region 204 is a region which separates the first lower end region 202 from the other regions. The separation region 204 of the present example includes an N type region which separates the well region 11 and the first lower end region 202. The N type region is, for example, a drift region 18. The N type region is arranged to surround the first lower end region 202 in a top view. The well region 11 is arranged to surround the separation region 204 in a top view. In Fig. 4, the separation region 204 is hatched with diagonal lines. By providing the separation region 204 between the well region 11 and the first lower end region 202, the first lower end region 202 is prevented from having the same potential as that of the well region 11. In this way, the first lower end region 202 is suppressed from having an emitter potential, and the transistor portion 70 and the diode portion 80 can be operated.

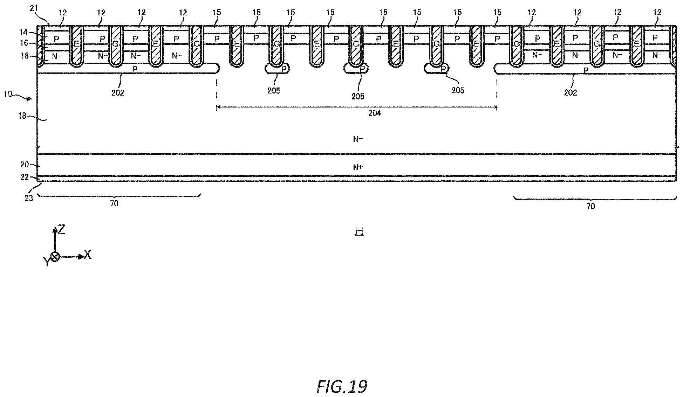

In the present example, the separation region 204 is provided in the entire area in the active portion 160 in which the first lower end region 202 is not provided. Note that when a portion in which the first lower end region 202 is not provided inside the active portion 160 as shown Fig. 19 exists, the portion may be provided with the separation region 204. The separation region 204 arranged inside the active portion 160 may be surrounded by the first lower end region 202 in a top view.

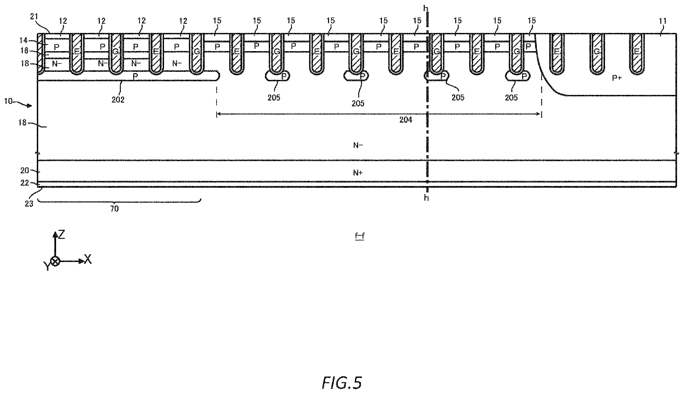

Fig. 5 shows an example of a cross section f-f in Fig. 4. The cross section f-f is an XZ plane which passes through the first lower end region 202, the separation region 204 and the well region 11. That is, the cross section f-f is the XZ plane in the vicinity of a boundary between the active portion 160 and the well region 11. Note that Fig. 5 shows a structure of the semiconductor substrate 10 and omits components such as an electrode and a dielectric film arranged above and below the semiconductor substrate 10. Also, Fig. 5 shows the gate trench portion 40 with a symbol G and the dummy trench portion 30 with a symbol E.

The cross section f-f shown in Fig. 5 includes a transistor portion 70 which is arranged at the endmost in the X axis direction among a plurality of transistor portions 70. A structure of the transistor portion 70 is similar to that of the transistor portion 70 described in Fig. 2 and Fig. 3. Note that in Fig. 5, one dummy trench portion 30 is arrayed between two gate trench portions 40 as G/E/G/E/· · , but two dummy trench portions 30 may be arrayed between two gate trench portions 40 as G/E/E/G/E/E/· · . An array of the gate trench portions 40 and the dummy trench portions 30 may have another structure. Also, a plurality of trench portions of the separation region 204 may be arranged with a constant interval in the X axis direction. The interval between the trench portions of the separation region 204 may be the same as the interval between the trench portions of the transistor portion 70.

The first lower end region 202 is provided at the lower end of the trench portion of the transistor portion 70. A center of the gate trench portion 40 (G) arranged at the end in the X axis direction among the gate trench portions 40 (G) provided in direct contact with the emitter regions 12 is defined as an end portion of the transistor portion 70 in the X axis direction. The first lower end region 202 may extend outward farther than the transistor portion 70 in the X axis direction. That is, the first lower end region 202 may extend to a region in which a gate structure including the gate trench portion 40 and the emitter region 12 is not provided.

The well region 11 is provided from the upper surface 21 of the semiconductor substrate 10 to below the base region 14. The well region 11 is a region of a P+ type having a higher doping concentration than the base region 14.

A region between the first lower end region 202 and the well region 11 in a top view is referred to as an separation region 204. The separation region 204 is provided with one or more trench portions. The separation region 204 of the present example is provided with one or more gate trench portions 40 and one or more dummy trench portions 30. The arrangement of the trench portions of the separation region 204 in the X axis direction may be the same as or may be different from that of the transistor portion 70.

Each mesa portion of the separation region 204 is provided with the base region 14. The contact region 15 may be provided between the base region 14 and the upper surface 21 of the semiconductor substrate 10. Also, the emitter region 12 may be provided between the base region 14 and the upper surface 21 of the semiconductor substrate 10. Also, the mesa portion of the separation region 204 may be provided with or may not be provided with an accumulation region 16. For example, the accumulation region 16 may be provided in one or more mesa portions located to be the closest to the transistor portion 70 among the mesa portions of the separation region 204.

The first lower end region 202 of the present example is a P type region having a doping concentration lower than that of the well region 11. The first lower end region 202 is arranged in at least a partial region of the transistor portion 70. The first lower end region 202 of the present example extends closer to the well region 11 than the end portion of the transistor portion 70. In another example, the first lower end region 202 may be terminated at the end portion of the transistor portion 70 or may be terminated inside the transistor portion 70.

The separation region 204 has one or more second lower end regions 205. The second lower end region 205 is a second conductivity type region provided to be in contact with the lower ends of one or more trench portions each including a gate trench portion 40. A doping concentration of the second lower end region 205 may be higher than, may be lower than, or may be the same as that of the first lower end region 202.

The second lower end regions 205 may be provided in series along an extending direction of the trench portion (the Y axis direction). A length of the second lower end region 205 in the Y axis direction may be the same as a length of the first lower end region 202 in the Y axis direction, or may be 80% or more or 120% or less of a length of the first lower end region 202 in the Y axis direction. The second lower end region 205 may be provided discretely along the extending direction of the trench portion (the Y axis direction).

The second lower end region 205 is provided between the first lower end region 202 and the well region 11 in a top view. The second lower end region 205 of the present example is provided between the first lower end region 202 and the well region 11 in the X axis direction. The second lower end region 205 is provided to be separated from the first lower end region 202 and the well region 11. An N type region such as a drift region 18 is provided between the second lower end region 205 and the first lower end region 202 in a top view. An N type region such as a drift region 18 is provided between the second lower end region 205 and the well region 11 in a top view. Also, when a plurality of second lower end regions 205 are provided, an N type region such as a drift region 18 is provided between two second lower end regions 205 in a top view.

In the X axis direction, a distance between the first lower end region 202 and the second lower end region 205 may be greater than or may be less than a width of the mesa portion in the separation region 204. Also, in the X axis direction, a distance between adjacent two second lower end regions 205 may be greater than or may be less than a width of the mesa portion in the separation region 204.

Also, in the X axis direction, a distance between the well region 11 and the second lower end region 205 may be greater than or may be less than a width of the mesa portion in the separation region 204.

Note that a potential of the second lower end region 205 is different from a potential of the emitter electrode 52. The second lower end region 205 is arranged, in the Z axis direction, apart from the base region 14 which is connected to the emitter electrode 52. Also, the second lower end region 205 is arranged, in a top view, apart from the well region 11 which is connected to the emitter electrode 52. The second lower end region 205 may be an electrically floating region to which no electrode is connected.

As described above, by providing the first lower end region 202, a potential increase near the lower end of the trench portion when the semiconductor device 100 is turned on can be suppressed. Thus, it is possible to reduce a slope (dv/dt) of a waveform of emitter-collector voltage at the time of turn-on and to reduce noise in a voltage or current waveform at the time of switching. Also, by providing the separation region 204, the first lower end region 202 and the well region 11 can be separated from each other, and the transistor portion 70 and the diode portion 80 can be operated. On the other hand, an imbalance occurs between an electric field near the lower end of the trench portion of a region in which the first lower end region 202 exists and an electric field near the lower end of the trench portion of a region in which the first lower end region 202 does not exist. In particular, due to an electric field strength near the lower end of the gate trench portion 40 where the first lower end region 202 is not provided, an avalanche can easily be generated and a clamp withstand capability and a latch-up resistance decrease.

Meanwhile, in the semiconductor device 100, the second lower end region 205 is provided at the lower end of at least one of the gate trench portion 40 in the separation region 204. In this way, the electric field strength near the lower end of the gate trench portion 40 of the separation region 204 can be relaxed. Thus, the breakdown voltage or the withstand capability of the semiconductor device 100 can be improved.

The second lower end region 205 may be provided for each of two or more gate trench portions 40 of the separation region 204. Each of the second lower end regions 205 is separated from each other. In the example of Fig. 5, the second lower end region 205 is provided at the lower end of each of all the gate trench portions 40 in the separation region 204. In the present example, each second lower end region 205 is in contact with the lower end of one of the gate trench portions 40 and not in contact with the lower end of another one of the gate trench portions 40 other than the above-described one of the gate trench portions 40. In the example of Fig. 5, each second lower end region 205 is in contact with the lower end of one of the gate trench portions 40, and not in contact with the lower end of the other trench portions. A width of the second lower end region 205 in the X axis direction may be less than, may be the same as, or may be larger than a width of the gate trench portion 40 in the X axis direction. The second lower end region 205 preferably covers the lowest part of the gate trench portion 40 (the bottom surface of the gate trench portion 40).

The second lower end region 205 may have a portion which is provided at a same depth position as the first lower end region 202. That is, a range in the Z axis direction in which the second lower end region 205 is provided and a range in the Z axis direction in which the first lower end region 202 is provided may at least partially overlap. At least one of the drift region 18 or the accumulation region 16 may be arranged between the second lower end region 205 and the base region 14.

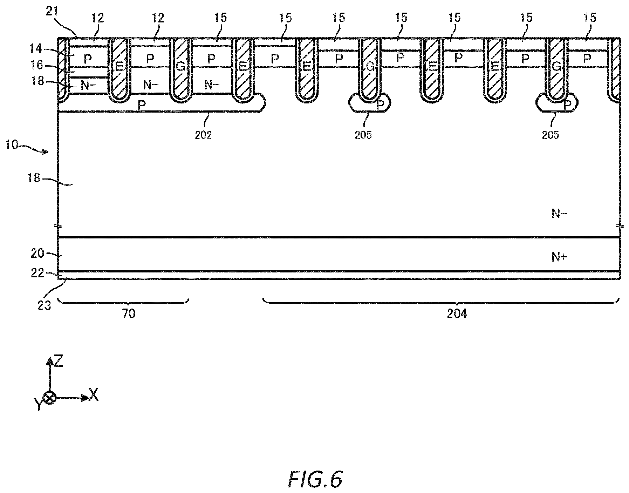

Fig. 6 shows another array example of the gate trench portion 40 and the dummy trench portion 30. The active portion 160 of the present example is provided with two dummy trench portions 30 between two gate trench portions 40. Also, the gate trench portions 40 are not arranged in series in the X axis direction. That is, one gate trench portion 40 and two dummy trench portions 30 are alternately arranged. Other structures are similar to those in the examples described in Fig. 1 to Fig. 5. Also in the present example, the one or more gate trench portions 40 of the separation region 204 are provided with the second lower end region 205.

Also in the example of any of Fig. 5 or Fig. 6, the number of trench portions in contact with one of the second lower end regions 205 is less than the number of trench portions in contact with one of the first lower end regions 202. For example, in the example of Fig. 6, while the number of trench portions in contact with one of the second lower end regions 205 is 1, one of the first lower end regions 202 is in contact with a plurality of trench portions. One of the first lower end regions 202 may be in contact with lower ends of a plurality of gate trench portions 40 and a plurality of dummy trench portions 30.

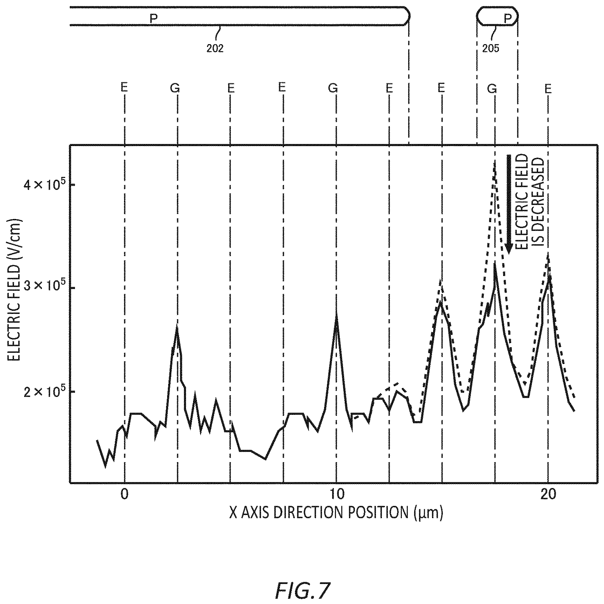

Fig. 7 shows a distribution example of an electric field at a depth position of the lower end of the trench portion in an X axis direction. Fig. 7 shows, for a current five times or more (six times in the present example) of the rated current, an electric field distribution when the transistor portion 70 is turned off. Fig. 7 shows a position of the lower end of the gate trench portion 40 in the X axis direction with a symbol G, and shows a position of the lower end of the dummy trench portion 30 in the X axis direction with a symbol E. Also, it schematically shows positions in the X axis direction in which the first lower end region 202 and the second lower end region 205 are provided. Note that the solid lines in Fig. 7 are an electric field distribution when the first lower end region 202 and the second lower end region 205 are provided as shown in Fig. 6, and the dashed line is an electric field distribution when the second lower end region 205 is not provided and only the first lower end region 202 is provided.

When the second lower end region 205 is not provided, as shown with the dashed line of Fig. 7, the electric field at the lower end of the trench portion which is not covered by the first lower end region 202 increases. In particular, the electric field strength at the lower end of the gate trench portion 40 (G) significantly increases. Thus, due to an electric field strength near the lower end of the gate trench portion 40, an avalanche can easily be generated and a clamp withstand capability and a latch-up resistance decrease.

Meanwhile, by providing the second lower end region 205, as shown with the solid lines of Fig. 7, the electric field near the lower end of the gate trench portion 40 can be decreased. Thus, the breakdown voltage and the withstand capability of the semiconductor device 100 can be improved.

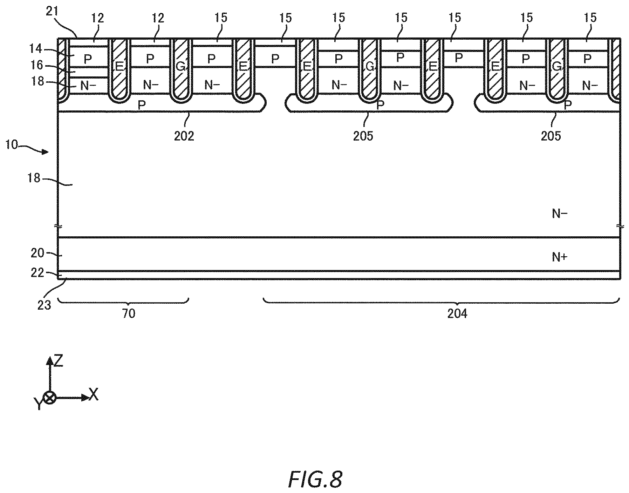

Fig. 8 shows another example of the second lower end region 205. The second lower end region 205 of the present example is in contact with the lower end of one of the gate trench portions 40, and is in contact with the lower end of the dummy trench portion 30 which is arranged adjacent to the gate trench portion 40 in the X axis direction. In the example of Fig. 8, the second lower end region 205 is in contact with the lower end of one of the gate trench portions 40, and in contact with the lower ends of two dummy trench portions 30 with the gate trench portion 40 sandwiched therebetween in the X axis direction. The second lower end region 205 is not provided below the mesa portion 60 which is sandwiched by adjacent dummy trench portions 30. That is, the second lower end region 205 which is provided for the adjacent dummy trench portions 30 is separated. In a top view, an N type region is provided between the separated two second lower end region 205. The N type region is, for example, a drift region 18. By such a configuration, an electric field strength near the lower ends of these dummy trench portions 30 can be relaxed. Thus, the breakdown voltage and the withstand capability of the semiconductor device 100 can be further improved.

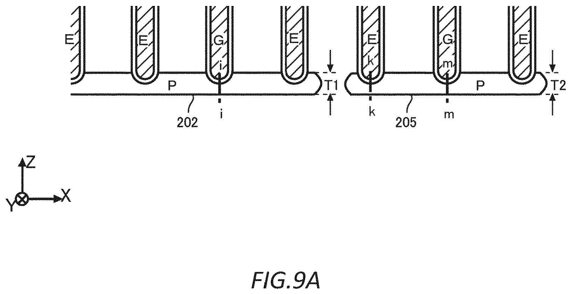

Fig. 9A is an enlarged drawing showing a region near the first lower end region 202 and the second lower end region 205. The second lower end region 205 of the present example is in contact with the lower end of a plurality of trench portions. A doping concentration of the second lower end region 205 at the lower end of the gate trench portion 40 is referred to as Dg. The doping concentration Dg may be the maximum value or may be an average value obtained by dividing an integrated value I_{D}g of a doping concentration of the second lower end region 205 on a line m-m which passes through the lowest point of the gate trench portion 40 and which is parallel to the Z axis, with a width T2 of a depth direction to the lower end from the upper end of the second lower end region 205. Similarly, a doping concentration of the second lower end region 205 at the lower end of the dummy trench portion 30 is referred to as Dd. The doping concentration Dd may be an average value or may be the maximum value obtained by dividing an integrated value I_{D}d of a doping concentration of the second lower end region 205 on a line k-k which passes through the lowest point of the dummy trench portion 30 and which is parallel to the Z axis, with a width T2 of a depth direction of the lower end from the upper end of the second lower end region 205.

The doping concentration Dg may be greater than the doping concentration Dd. The integrated value I_{D}g may be greater than the integrated value I_{D}d. As shown in Fig. 7, since an electric field strength can more easily occur in the gate trench portion 40 than in the dummy trench portion 30, by increasing the doping concentration Dg or the integrated value I_{D}g to be relatively large, the electric field strength for the gate trench portion 40 can be relaxed, and the breakdown voltage and the withstand capability of the semiconductor device 100 can be improved.

Also, a doping concentration of the first lower end region 202 at the lower end of the gate trench portion 40 is referred to as D1. The doping concentration D1 may be an average value or may be the maximum value obtained by dividing an integrated value I_{D}1 of a doping concentration of the first lower end region 202 on a line i-i which passes through the lowest point of the gate trench portion 40 and which is parallel to the Z axis, with a width T1 of a depth direction of the lower end from the upper end of the first lower end region 202. The first lower end region 202 may have the same doping concentration at the lower end of the gate trench portion 40 and the lower end of the dummy trench portion 30.

The doping concentration Dg may be greater than the doping concentration D1. The integrated value I_{D}g may be greater than the integrated value I_{D}1. In this way, an electric field strength with respect to the gate trench portion 40 in the separation region 204 can be relaxed. The doping concentration Dg may be twice or more, may be five times or more, or may be ten times or more of the doping concentration D1. Also, the doping concentration Dd may be less than the doping concentration D1. The integrated value I_{D}g may be twice or more, may be five times or more, or may be ten times or more of the integrated value I_{D}1. Also, the integrated value I_{D}d may be less than the integrated value I_{D}1. Such configuration can cause the electric field of the lower end of each trench portion to be easily equalized. The doping concentration Dd may be 0.5 times or less, may be 0.2 times or less, or may be 0.1 times or less of the doping concentration D1. The integrated value I_{D}d may be 0.5 times or less, may be 0.2 times or less, or may be 0.1 times or less of the integrated value I_{D}1.

Also, the number of trench portions in contact with one of the first lower end regions 202 is referred to as q. In the example of Fig. 8, q is an integer greater than or equal to 4. A sum of doping concentrations at the lower end of each trench portion of one of the first lower end regions 202 is referred to as Dsum1. Similarly, the number of trench portions in contact with one of the second lower end regions 205 is referred to as r. In the example of Fig. 8, r is 3. A sum of doping concentrations at the lower end of each trench portion of one of the second lower end regions 205 is referred to as Dsum2. Dsum2/r may be less than Dsum1/q. That is, an average value of each doping concentration at the lower end which is in contact with each trench portion of the one of the second lower end regions 205 may be less than an average value of each doping concentration at the lower end which is in contact with each trench portion of one of the first lower end regions 202.

Also, in each trench portion of one of the first lower end regions 202, a sum of an integrated value of the doping concentration of the first lower end region 202 on a line m-m which passes through the lowest point of each trench portion and which is parallel to the Z axis is referred to as I_{D}sum1. Similarly, the number of trench portions in contact with one of the second lower end regions 205 is referred to as r. In the example of Fig. 8, r is 3.

In each trench portion of one of the second lower end regions 205, a sum of an integrated value of the doping concentration of the first lower end region 202 on a line m-m which passes through the lowest point of each trench portion and which is parallel to the Z axis is referred to as I_{D}sum2. I_{D}sum2/r may be less than I_{D}sum1/q. That is, the integrated value of the doping concentration of each trench portion in contact with one of the second lower end regions 205 may be less than an integrated value of the doping concentration of each trench portion in contact with one of the first lower end regions 202.

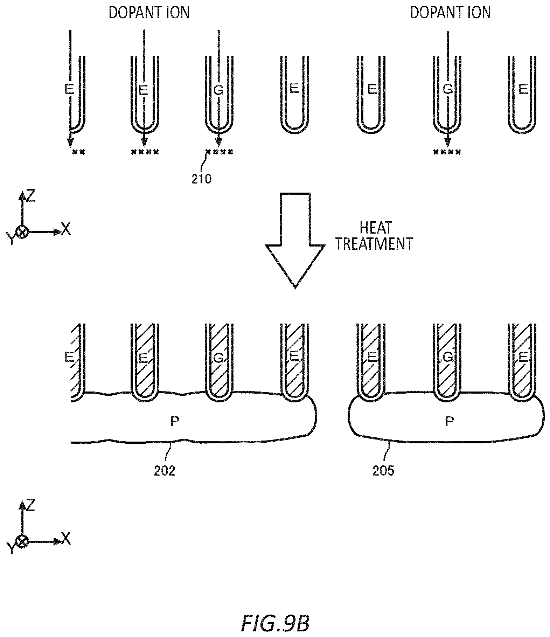

Fig. 9B shows an example of the formation process of Fig. 9A. As an example, the first lower end region 202 is formed by implanting a P type dopant by a certain first dose amount to each lower end of the gate trench portion 40 and the dummy trench portion 30. By performing heat treatment for the semiconductor substrate 10 after implanting the P type dopant, the P type dopant at the lower end of each trench portion diffuses in the X axis direction, to form the first lower end region 202 in series. By ion implantation or the like, the P type dopant can be introduced below the trench portion. By the heat treatment, the P type dopant diffuses in a depth direction (the Z axis direction) and a lateral direction (the X axis direction). The P type dopants which are diffused in the lateral direction from below the adjacent trench portion overlaps at the center part of the mesa portion. Consequently, as shown in Fig. 9B, the doping concentration of the first lower end region 202 slightly decreases at the center portion of the mesa portion. Furthermore, an end portion in the lateral direction of the first lower end region 202 may be extended to: a dummy trench portion 30 which is positioned in an -X axis direction end portion on an separation region 204 side; or alternatively the mesa portion.

On the other hand, in the separation region 204, a P type dopant may be implanted by a certain first dose amount to the lower end of the gate trench portion 40. By performing heat treatment for the semiconductor substrate 10 after implanting the P type dopant, the P type dopant which is implanted to the lower end of the gate trench portion 40 diffuses in the X axis direction, to reach the lower end of the dummy trench portion 30. In this case, an average value of each doping concentration at the lower end of each trench portion of the second lower end region 205 is less than an average value of each doping concentration at the lower end of each trench portion of the first lower end region 202. Such a configuration prevents the second lower end region 205 from being excessively expanded in the X axis direction and being connected to the first lower end region 202 or the well region 11.

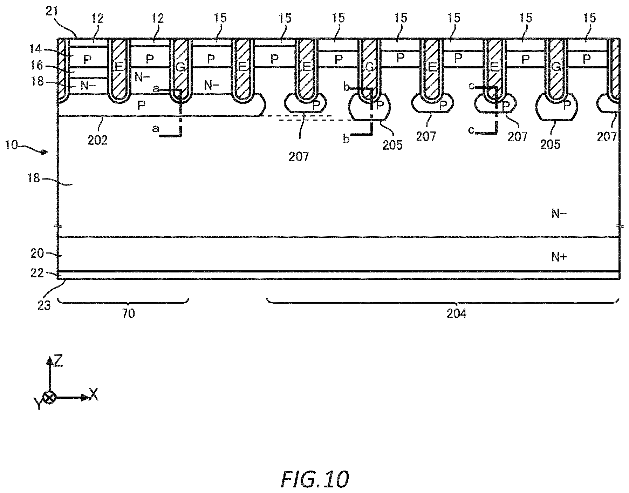

Fig. 10 shows another configuration example of the separation region 204. The separation region 204 of the present example is different from the separation region 204 described in Fig. 1 to Fig. 9B in that it includes the third lower end region 207. The other structures are similar to those of any of the separation regions 204 described in Fig. 1 to Fig. 9B.

The third lower end region 207 is provided for the one or more dummy trench portions 30 in the separation region 204. The third lower end region 207 is provided to be in contact with the lower end of the dummy trench portion 30 and is not in contact with the lower end of the trench portion which is adjacent to the dummy trench portion 30. The third lower end region 207 is provided to be separated from all of the first lower end region 202, the second lower end region 205 and the well region 11. An N type region such as a drift region 18 is provided between the third lower end region 207, the first lower end region 202, the second lower end region 205 and the well region 11.

Note that a potential of the third lower end region 207 is different from a potential of the emitter electrode 52. The third lower end region 207 is arranged, in the Z axis direction, apart from the base region 14 which is connected to the emitter electrode 52. Also, the third lower end region 207 is arranged, in a top view, apart from the well region 11 which is connected to the emitter electrode 52. The third lower end region 207 may be an electrically floating region to which no electrode is connected.

The dummy trench portion 30 with which the third lower end region 207 is in contact is arranged adjacent to the gate trench portion 40 with which the second lower end region 205 is in contact. In the present example, the second lower end region 205 is provided for all of the gate trench portions 40 of the separation region 204, and the third lower end region 207 is provided for all of the dummy trench portions 30 of the separation region 204. Also by the present example, the electric field strength at the lower end of each trench portion of the separation region 204 can be relaxed.

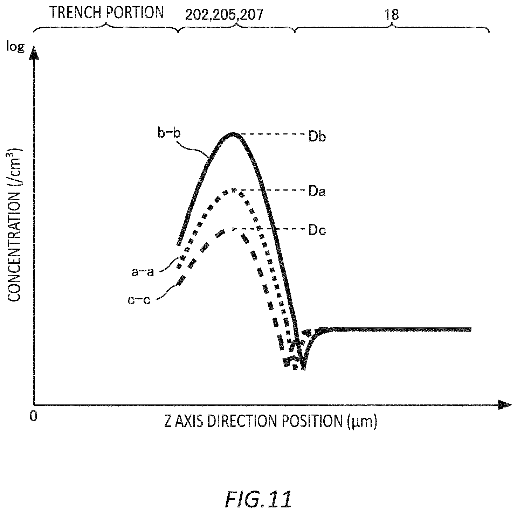

Fig. 11 shows doping concentration distribution examples of the first lower end region 202, the second lower end region 205 and the third lower end region 207 in a Z axis direction. A doping concentration distribution of the first lower end region 202 is a distribution on the line a-a (see Fig. 10) which passes through the lowest point of the gate trench portion 40 and which is parallel to the Z axis. A doping concentration distribution of the second lower end region 205 is a distribution on the line b-b (see Fig. 10) which passes through the lowest point of the gate trench portion 40 and which is parallel to the Z axis. A doping concentration distribution of the third lower end region 207 is a distribution on the line c-c (see Fig. 10) which passes through the lowest point of the dummy trench portion 30 and which is parallel to the Z axis.

A peak value of the doping concentration of the first lower end region 202 is referred to as Da, a peak value of the doping concentration of the second lower end region 205 is referred to as Db, and a peak value of the doping concentration of the third lower end region 207 is referred to as Dc. The peak value Db may be greater than the peak value Da. The peak value Db may be twice or more, may be five times or more, or may be ten times or more of the peak value Da. The peak value Da may be greater than the peak value Dc. The doping concentration Da may be twice or more, may be five times or more, or may be ten times or more of the doping concentration Dc. At the PN junction of the drift region 18, the second lower end region 205 may be positioned at a position which is the closest to the lower surface 23 side (+Z axis direction side), and the third lower end region 207 may be positioned at a position which is the closest to the upper surface 21 side (-Z axis direction side).

Also, an integrated value which is obtained by integrating the doping concentration of the first lower end region 202 from the lower end of the gate trench portion 40 to the upper end of the drift region 18 is referred to as la, an integrated value which is obtained by integrating the doping concentration of the second lower end region 205 from the lower end of the gate trench portion 40 to the upper end of the drift region 18 is referred to as Ib, and an integrated value which is obtained by integrating the doping concentration of the third lower end region 207 from the lower end of the dummy trench portion 30 to the upper end of the drift region 18 is referred to as Ic. The integrated value Ib may be greater than the integrated value la. The integrated value Ib may be twice or more, may be five times or more, or may be ten times or more of the integrated value la. The integrated value la may be greater than the integrated value Ic. The integrated value la may be twice or more, may be five times or more, or may be ten times or more of the integrated value Ic.

Note that the doping concentration distribution on the line i-i in Fig. 9A may be similar to the doping concentration distribution on the line a-a of the present example. Note that the doping concentration distribution on the line m-m in Fig. 9A may be similar to the doping concentration distribution on the line b-b of the present example. The doping concentration distribution on the line k-k in Fig. 9A may be similar to the doping concentration distribution on the line c-c of the present example.

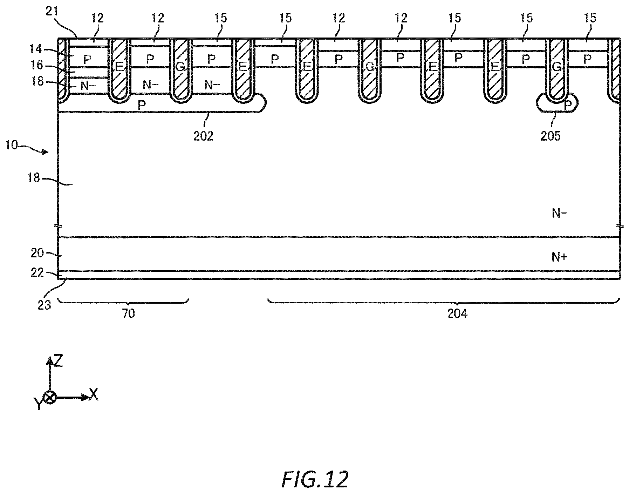

Fig. 12 shows another example of the separation region 204. The separation region 204 of the present example has an arrangement of the second lower end region 205 which is different from the example described in Fig. 1 to Fig. 11. Other structures are similar to any of the examples described in Figs. 1 to 11.

In the separation region 204 of the present example, a lower end of at least one of the gate trench portions 40 is not provided with the second lower end region 205. That is, at least the lower end of the gate trench portion 40 is in contact with an N type region such as a drift region 18. In the separation region 204, in a mesa portion which is in contact with the gate trench portion 40 which is not provided with the second lower end region 205, an emitter region 12 may be provided. In this way, when the gate trench portion 40 which is not provided with the second lower end region 205 is in an ON state, electrons can be easily supplied for the drift region 18. In this way, the carrier concentration in the drift region 18 can be increased and the ON resistance can be reduced.

Among the gate trench portions 40 of the separation region 204, the lower end of the gate trench portion 40 which is the closest to the first lower end region 202 may be in in contact with the drift region 18. In this way, electrons can be supplied in the vicinity of the transistor portion 70.

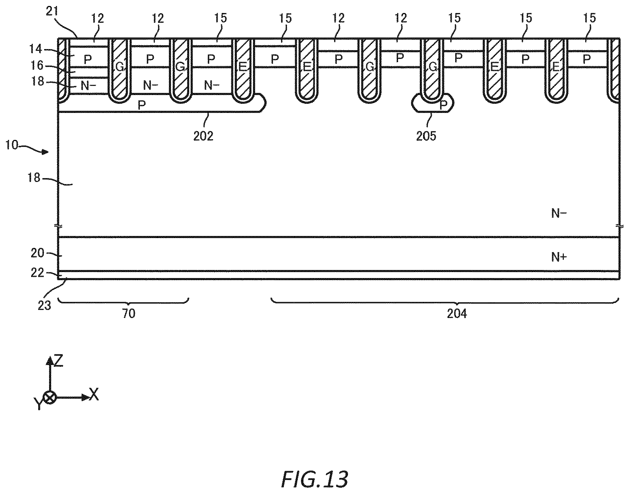

Fig. 13 shows another example of the separation region 204. In the semiconductor substrate 10 of the present example, two gate trench portions 40 and two dummy trench portions 30 are arranged alternately. That is, the semiconductor substrate 10 has two gate trench portions 40 arranged adjacent to each other without sandwiching the dummy trench portion 30 therebetween in the X axis direction, and two dummy trench portions 30 arranged adjacent to each other without sandwiching the gate trench portion 40 therebetween. The structure other than the array of the trench portions is similar to any of the examples described in Fig. 1 to Fig. 12.

In the separation region 204 of the present example, a lower end of at least one of the gate trench portions 40 is not provided with the second lower end region 205. In the present example, among two gate trench portions 40 arranged in series, one gate trench portion 40 is provided with the second lower end region 205 and the other gate trench portion 40 is not provided with the second lower end region 205. By such a configuration, the electron supply function can be maintained while relaxing the electric field strength with respect to a pair of gate trench portions 40. Among the pair of gate trench portions 40, the gate trench portion 40 which is farther from the transistor portion 70 is provided with the second lower end region 205 and the gate trench portion 40 which is closer to the transistor portion 70 may not be provided with the second lower end region 205. In this way, electrons can be supplied relatively near the transistor portion 70 while relaxing the electric field strength.

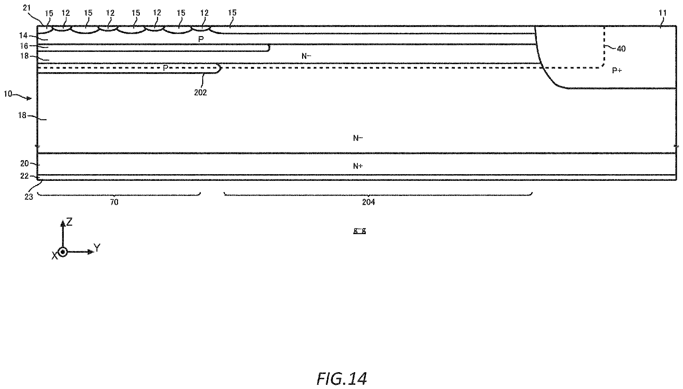

Fig. 14 shows an example of a cross section g-g in Fig. 4. The cross section g-g is a YZ plane which passes through the first lower end region 202 and the well region 11. The cross section g-g passes through a mesa portion of the transistor portion 70. However, in Fig. 14, a position at which the gate trench portion 40 is projected on the cross section g-g is indicated by a dashed line. Note that Fig. 14 shows a structure of the semiconductor substrate 10 and omits components such as an electrode and a dielectric film arranged above and below the semiconductor substrate 10.

In the cross section, the separation region 204 is also provided between the transistor portion 70 and the well region 11. However, the separation region 204 in the cross section is not provided with the second lower end region 205 and the third lower end region 207. The drift region 18 is provided between the first lower end region 202 and the well region 11.

The emitter region 12 and the contact region 15 are alternately arranged along the Y axis direction in the upper surface 21 of the transistor portion 70. The contact region 15 is provided in the upper surface 21 of the separation region 204.

The accumulation region 16 of this example is provided to extend closer to the well region 11 than an end portion of the transistor portion 70. In another example, the accumulation region 16 may be terminated at the end portion of the transistor portion 70 or may be terminated inside the transistor portion 70.

The first lower end region 202 of the present example extends closer to the well region 11 than the end portion of the transistor portion 70. In another example, the first lower end region 202 may be terminated at the end portion of the transistor portion 70 or may be terminated inside the transistor portion 70. The accumulation region 16 may extend to a position which is closer to the well region 11 than the first lower end region 202.

The separation region 204 may overlap with the accumulation region 16 in a top view. That is, the end portion of the accumulation region 16 may exist inside the separation region 204 in a top view. In another example, the separation region 204 may not overlap with the accumulation region 16 in a top view. That is, the end portion of the accumulation region 16 may exist inside (-Y axis direction side) from the separation region 204 in a top view. In the cross section, the separation region 204 may be provided not to overlap with the transistor portion 70. In another example, in the cross section, the separation region 204 may overlap with the transistor portion 70.

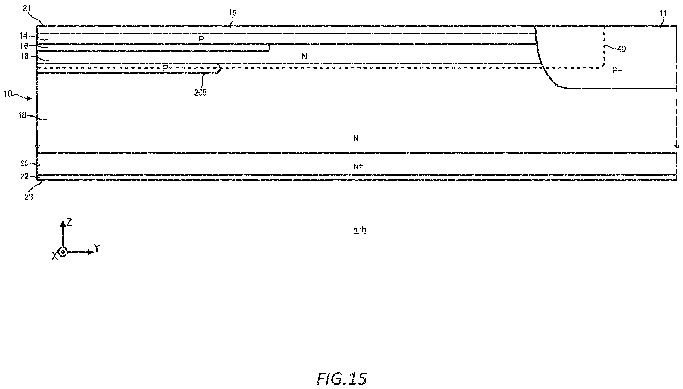

Fig. 15 shows an example of the cross section h-h in Fig. 5, that does not fall under the scope of the present invention, but it useful for understanding it. The cross section h-h is a YZ plane which passes through the second lower end region 205 and the well region 11. A position in the Y axis direction of the cross section h-h is the same as that of the cross section g-g shown in Fig. 14. The cross section h-h passes through the mesa portion of the separation region 204. However, in Fig. 15, a position at which the gate trench portion 40 is projected on the cross section h-h is indicated by a dashed line. Note that Fig. 15 shows a structure of the semiconductor substrate 10 and omits components such as an electrode and a dielectric film arranged above and below the semiconductor substrate 10.

The semiconductor substrate 10 of the cross section is provided with the second lower end region 205 instead of the first lower end region 202 in the cross section shown in Fig. 14. Also, the contact regions 15 are provided in series on the upper surface 21 of the semiconductor substrate 10. Other structures are similar to those of the example described in Fig. 14. In the Y axis direction, a distance between the second lower end region 205 and the well region 11 may be the same as, may be greater than, or may be less than a distance between the first lower end region 202 and the well region 11.

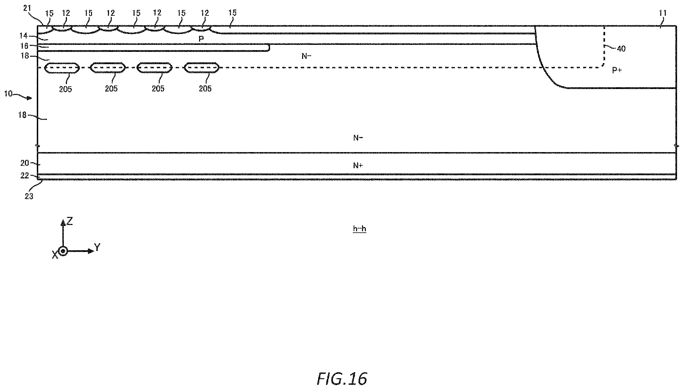

Fig. 16 shows a cross section h-h, for a device according to the present invention. In this cross section h-h, a structure on the upper surface 21 of the semiconductor substrate 10 is similar to the cross section g-g shown in Fig. 14. That is, the emitter region 12 and the contact region 15 are arranged alternately along the Y axis direction.

According to the invention, a plurality of second lower end regions 205 are arranged discretely and apart from each other along a longitudinal direction of the gate trench portion 40 (the Y axis direction). Structures other than the structure in the upper surface 21 of the semiconductor substrate 10 and the arrangement of the second lower end region 205 are similar to the example of Fig. 15. While relaxing the electric field strength by arranging the second lower end region 205 along the Y axis direction, the electron supply function can be maintained by discretely arranging the second lower end region 205. Note that the first lower end region 202 is preferably arranged in series in the Y axis direction as shown in Fig. 14. In this way, the voltage or current waveform noise during switching can be reduced in a wide range of the transistor portion 70 and the diode portion 80.

Each second lower end region 205 may be arranged to overlap with the emitter region 12 (or a source region 212) in a top view. The second lower end region 205 may be provided for each emitter region 12 (or the source region 212). Each second lower end region 205 may be arranged to cover the entire corresponding emitter region 12 (or the source region 212) in the Y axis direction. Since the electron current flows toward the emitter region 12, a relatively large current flows below the emitter region 12. By providing the second lower end region 205 below the emitter region 12, the electric field of a region in which a large current is flowing can be suppressed, and the withstand capability of the region can be improved.

In Fig. 15 and Fig. 16, a structure of the second lower end region 205 near the gate trench portion 40 in the Y axis direction is described, but the second lower end region 205 in the other regions has a similar structure in the Y axis direction. Also, the third lower end region 207 may have a structure in the Y axis direction which is similar to that of the second lower end region 205 described in Fig. 15 and Fig. 16.

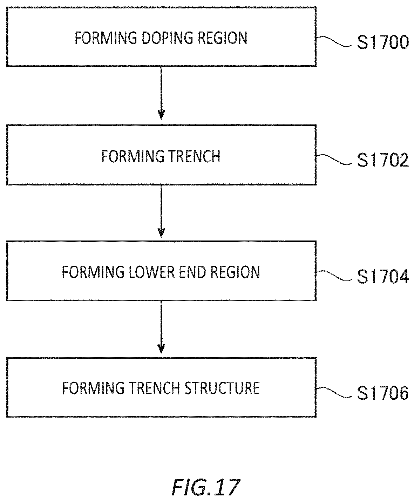

Fig. 17 shows a part of the process of the manufacturing method of the semiconductor device 100. In the manufacturing method of the semiconductor device 100, each configuration described in Fig. 1 to Fig. 16 is formed. The process shown in Fig. 17 includes a doping region forming step S1700, a trench forming step S1702, a lower end region forming step S1704 and a trench structure forming step S1706.

In the doping region forming step S1700, a doping region arranged on an upper surface 21 side of a semiconductor substrate 10 is formed. The doping region includes, for example, at least one of the well region 11, the emitter region 12, the base region 14, the contact region 15, or the accumulation region 16. Note that the drift region 18 may be a region remaining without the above described doping regions formed.

The trench forming step S1702 forms a trench in the upper surface 21 of the semiconductor substrate 10. The trench is a groove for forming each trench portion. Each trench is formed from the upper surface 21 to a depth reaching the drift region 18. The trench forming step S1702 does not form at least a conductive portion in the trench. A dielectric film in the trench may be formed or may not be formed.

The lower end region forming step S1704 forms a first lower end region 202 and a second lower end region 205. The lower end region forming step S1704 may form a third lower end region 207. The lower end region forming step S1704 may implant a P type dopant ion to the semiconductor substrate 10 via the trench. In the lower end region forming step S1704, the P type dopant ion may be implanted from the upper surface 21 of the semiconductor substrate 10 in a state in which the portions other than the trench are masked. This allows the dopant ion of the P type to be easily implanted into a region in contact with a lower end of the trench. In the doping region forming step S1700 and the lower end region forming step S1704, a heat treatment is performed for the semiconductor substrate 10 after the dopant is implanted.

The trench structure forming step S1706 forms the conductive portion and the dielectric film inside each trench. The trench structure forming step S1706 may form the dielectric film by thermally oxidizing an inner wall of the trench. The trench structure forming step S1706 may form the conductive portion by filling a conductive material such as polysilicon into the trench where the dielectric film is formed.

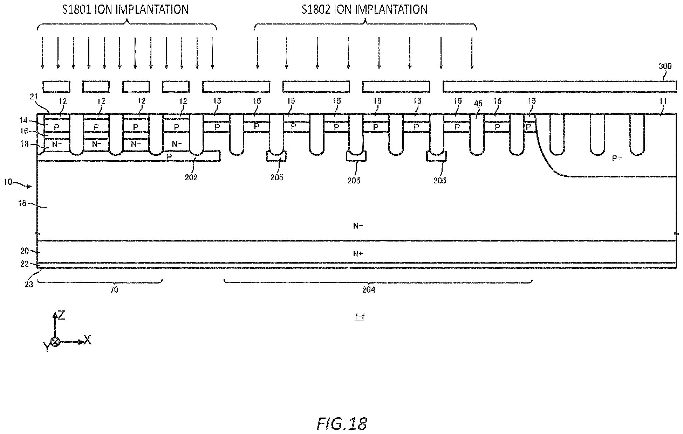

Fig. 18 illustrates an example of the lower end region forming step S1704. The lower end region forming step S1704 of the present example includes a first implantation step S1801 and a second implantation step S1802. Any one of the first implantation step S1801 and the second implantation step S1802 may be performed before the other one, or the two may be performed simultaneously.

In the first implantation step S1801, a P type dopant ion is implanted to a region in which a first lower end region 202 should be formed with a predetermined concentration (/cm²). In the first implantation step S1801 of the present example, the P type dopant ion is implanted from a bottom portion of each trench 45 of the gate trench portion 40 and the dummy trench portion 30.

In the second implantation step S1802, the P type dopant ion is implanted to a region in which the separation region 204 should be formed. In the second implantation step S1802 of the present example, the P type dopant ion is implanted from the bottom portion of each trench 45 of the gate trench portion 40. A dose amount (ions/cm²) per unit area in the second implantation step S1802 may be the same as, or may be different from a dose amount (ions/cm²) in the first implantation step S1801. When the first implantation step S1801 and the second implantation step S1802 is performed simultaneously, these dose amounts are the same. In the first implantation step S1801 and the second implantation step S1802, a mask 300 may mask a region other than the trench 45. Heat treatment diffuses the dopant implanted via the trench 45. In this way, first lower end regions 202 can be formed in series in an XY plane. Also, depending on the conditions of the heat treatment, whether the second lower end region 205 is to be formed to reach the lower end of the adjacent trench 45 can be controlled.

The manufacturing method may further include a third implantation step for forming the third lower end region 207. When a doping concentration of the third lower end region 207 is made to be different from a doping concentration of the second lower end region 205, the third implantation step is performed with a different process from the second implantation step S1802.

FIG. 19 is a drawing showing an example of a cross section j-j in FIG. 4.

Fig. 19 shows an example of the cross section j-j in the Fig. 4. The cross section j-j is an XZ plane which passes through the active portion 160. The semiconductor device 100 of the present example has an separation region 204 inside the active portion 160. The structure of the separation region 204 is similar to that of the separation region 204 in any of the aspects described in the present specification. The separation region 204 is provided with one or more second lower end regions 205.

The separation region 204 of the present example is sandwiched between two first lower end regions 202 in a top view. In the example of Fig. 19, the separation region 204 is sandwiched between two first lower end regions 202 in the X axis direction. The separation region 204 may be provided with a plurality of second lower end regions 205. As shown in Fig. 19, the separation region 204 may be provided between two transistor portions 70 in the X axis direction. The transistor portion 70 may be provided between two separation regions 204 in the X axis direction.

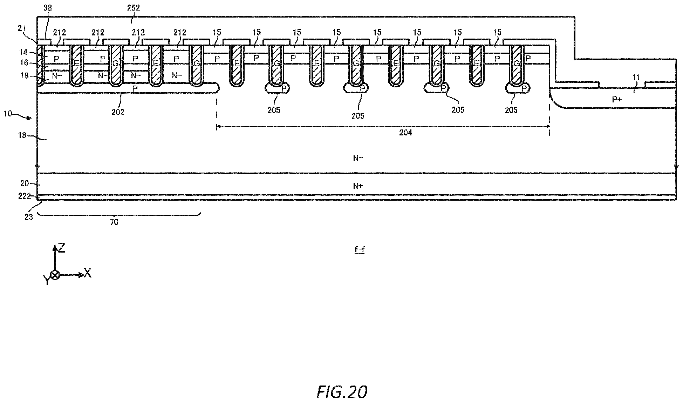

Fig. 20 shows another example of the cross section f-f. In Fig. 20, the structure above the upper surface 21 of the semiconductor substrate 10 is also shown. The semiconductor device 100 of the present example is a MOSFET.

The semiconductor device 100 has, instead of the collector region 22 in each example described in the present specification, an N+ type drain region 222 which is provided to be in contact with the lower surface 23 of the semiconductor substrate 10. Also, the emitter region 12 and the emitter electrode 52 in each example described in the present specification function as the source region 212 and a source electrode 252. The source region 212 and the source electrode 252 each have a similar structure as that of the emitter region 12 and the emitter electrode 52. Also, the collector electrode 24 in each example described in the present specification (see Fig. 3 or the like) functions as a drain electrode. The semiconductor substrate 10 may be a SiC (silicon carbide) substrate.

The semiconductor substrate 10 may have a step portion (a concave portion) at the end portion in a top view. The well region 11 may be formed on the step portion. The well region 11 may function as JTE (Junction Termination Extension).

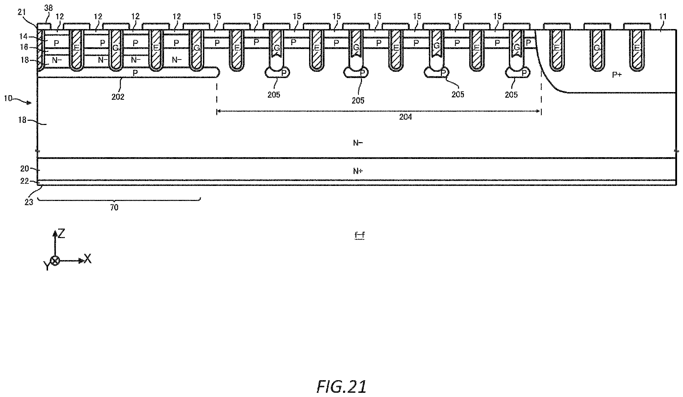

Fig. 21 shows another structural example of the separation region 204. The separation region 204 of the present example may be applied to the semiconductor device 100 in any one of the aspects described in the present specification. In the present example, a gate conductive portion 44 of at least one of the gate trench portions 40 among the gate trench portions 40 in contact with the second lower end region 205 is shorter than a gate conductive portion 44 of the gate trench portion 40 in contact with the first lower end region 202 in a depth direction. A gate conductive portion 44 of all of the gate trench portions 40 in contact with the second lower end region 205 may be shorter than a gate conductive portion 44 of the gate trench portion 40 in contact with the first lower end region 202 in a depth direction.

A length of the gate conductive portion 44 of the gate trench portion 40 in contact with the second lower end region 205 may be 90% or less, may be 80% or less, or may be 70% or less of the length of the gate conductive portion 44 of the gate trench portion 40 in contact with the first lower end region 202. However, the gate conductive portion 44 of the gate trench portion 40 in contact with the second lower end region 205 may be provided to below the base region 14. In the present example, a gate dielectric film 42 at the lower end of the gate trench portion 40 in contact with the second lower end region 205 is thicker than a gate dielectric film 42 at the lower end of the gate trench portion 40 in contact with the first lower end region 202 in a depth direction.

According to the present example, since the gate dielectric film 42 at the lower end of the gate trench portion 40 in contact with the second lower end region 205 can be made thicker, the breakdown voltage of the gate trench portion 40 can be further increased. Each length of the gate trench portion 40 in contact with the first lower end region 202 and the gate trench portion 40 in contact with the second lower end region 205 in the depth direction may be the same or may be different from each other.

For at least one of the gate trench portions 40 in contact with the second lower end region 205, the gate conductive portion 44 may have, at the center of the lower surface thereof, a convex shape recessed upward. That is, the gate conductive portion 44 has a length at a position in contact with the gate dielectric film 42, which is greater than the length at a position which is the farthest from the gate dielectric film 42 in the X axis direction (That is, the center position of the gate conductive portion 44 in the X axis direction). Such a structure can ensure the length in a depth direction of a channel that is formed in the base region 14, and can relax the electric field intensity at the bottom portion of the gate trench portion to suppress the breakdown of the gate dielectric film, hot carrier injection or the like, to increase the reliability of the gate dielectric film. The length of the gate conductive portion 44 at the position in contact with the gate dielectric film 42 may be 1.05 times or more, may be 1.1 times or more, or may be 1.2 times or more of the length of the gate conductive portion 44 at the position which is the farthest from the gate dielectric film 42.

For the gate trench portion 40 in contact with the first lower end region 202, the gate conductive portion 44 may have, at the center of the lower surface thereof, a convex shape recessed downward. In another example, for the gate trench portion 40 in contact with the first lower end region 202, the gate conductive portion 44 may have, at the center of the lower surface, a convex shape recessed upward.

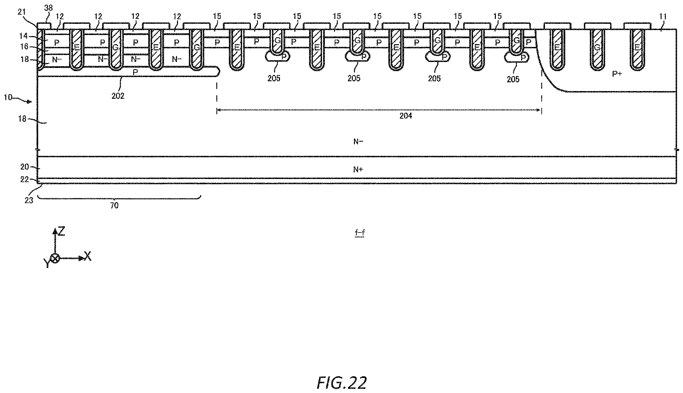

Fig. 22 shows another structural example of the separation region 204. The separation region 204 of the present example may be applied to the semiconductor device 100 in any one of the aspects described in the present specification. In the present example, at least one of the gate trench portions 40 in contact with the second lower end region 205 is shorter than the gate trench portion 40 in contact with the first lower end region 202 in the depth direction. All of the gate trench portions 40 in contact with the second lower end region 205 may be shorter than the gate trench portion 40 in contact with the first lower end region 202 in the depth direction. Such a structure can further relax the electric field strength with respect to the lower end of the gate trench portion 40 in the separation region 204. In the present example, a drift region 18 is interposed between the second lower end region 205 and the base region 14 in the depth direction. In other words, the drift region 18 is in contact with the gate trench portion 40 at the upper side of the second lower end region 205. However, the second lower end region 205 and the base region 14 may be directly connected, or may be indirectly connected via another P type semiconductor region.

The length of the gate trench portion 40 in contact with the second lower end region 205 may be 0.9 times or less, may be 0.8 times or less, or may be 0.7 times or less of the length of the gate trench portion 40 in contact with the first lower end region 202. However, the gate trench portion 40 in contact with the second lower end region 205 is formed to below the base region 14. The gate trench portion 40 in contact with the second lower end region 205 may be shorter than the dummy trench portion 30 in the depth direction, the dummy trench portion 30 being adjacent to the gate trench portion 40 in the X axis direction. The length of the dummy trench portion 30 may be the same as or may be different from the length of the gate trench portion 40 in contact with the first lower end region 202. The length of the gate trench portion 40 in contact with the second lower end region 205 may be 0.9 times or less, may be 0.8 times or less, or may be 0.7 times or less of the length of the adjacent dummy trench portion 30.

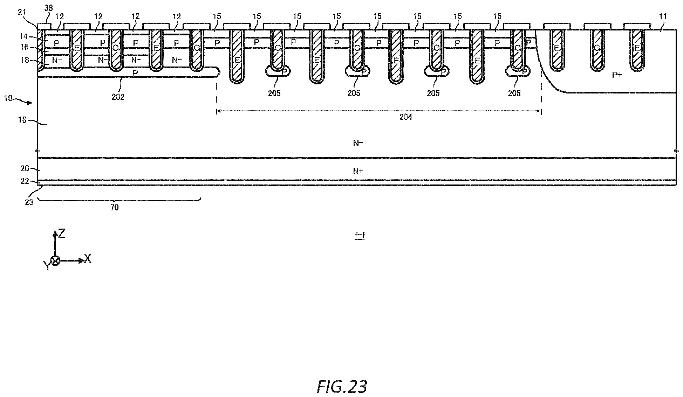

Fig. 23 shows another structural example of the separation region 204. The separation region 204 of the present example may be applied to the semiconductor device 100 in any one of the aspects described in the present specification. In the present example, at least one of the dummy trench portions 30 of the separation region 204 is longer than the dummy trench portion 30 in contact with the first lower end region 202 in the depth direction. All of the dummy trench portions 30 of the separation region 204 may be longer than the dummy trench portion 30 in contact with the first lower end region 202 in the depth direction. Such a structure can further relax the electric field strength with respect to the lower end of the gate trench portion 40 in the separation region 204. The length of the dummy trench portion 30 of the separation region 204 may be 1.1 times or more, may be 1.2 times or more, or may be 1.3 times or more of the length of the dummy trench portion 30 in contact with the first lower end region 202. The dummy trench portion 30 of the separation region 204 may be formed to be shallower than the well region 11.

The gate trench portion 40 in contact with the second lower end region 205 may be shorter than the dummy trench portion 30 in the depth direction, the dummy trench portion 30 being adjacent to the gate trench portion 40 in the X axis direction. The length of the gate trench portion 40 in contact with the second lower end region 205 may be the same as or may be different from the length of the gate trench portion 40 in contact with the first lower end region 202. The length of the gate trench portion 40 in contact with the second lower end region 205 may be 0.9 times or less, may be 0.8 times or less, or may be 0.7 times or less of the length of the adjacent dummy trench portion 30.

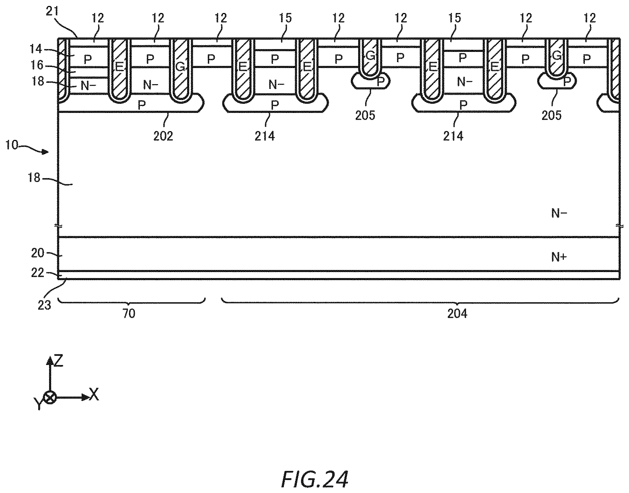

Fig. 24 shows another structural example of the separation region 204. The separation region 204 of the present example may be applied to the semiconductor device 100 in any one of the aspects described in the present specification. The separation region 204 in the present example has, adjacent to the gate trench portion 40 in contact with the first lower end region 202, two or more dummy trench portions 30 arranged in series, which are not in contact with the first lower end region 202 and the second lower end region 205. The separation region 204 of the present example further includes a fourth lower end region 214 of the second conductivity type that is provided to be in contact with the lower end of the two or more dummy trench portions 30. A depth position and a doping concentration of the fourth lower end region 214 may be the same as those of the first lower end region 202. The fourth lower end region 214 may be arranged between the first lower end region 202 and the second lower end region 205 in the X axis direction. The fourth lower end region 214 is separated from all of the first lower end region 202 and the second lower end region 205.

In the present example, a drift region 18 is interposed between the second lower end region 205 and the base region 14 in the depth direction. In the separation region 204, an emitter region 12 (or a source region 212) may be provided to the mesa portion in contact with the gate trench portion 40. According to the present example, at least a part of the separation region 204 can also be operated as the transistor portion. A second lower end region 205 is provided at the lower end of the gate trench portion 40. The second lower end region 205 may be sandwiched between two of the fourth lower end regions 214 in the X axis direction. Note that a part of the second lower end region 205 and the base region 14 may be directly connected, or may be indirectly connected via another P type semiconductor region.

The gate trench portion 40 and the second lower end region 205 in the separation region 204 are similar to those of any of the examples described in the present specification. In the example of Fig. 24, the gate trench portion 40 and the second lower end region 205 described in Fig. 22 are provided. In this way, the electric field strength with respect to the gate trench portion 40 can be relaxed. Also, the depth positions of the second lower end region 205 and the fourth lower end region 214 are different from each other, the second lower end region 205 and the fourth lower end region 214 can be easily separated and a current path also can be easily ensured.

While the present invention has been described by way of the embodiments, the technical scope of the present invention is not limited to the scope described in the above-described embodiments, but only by the scope of independent claim 1. It is apparent to persons skilled in the art that various alterations or improvements can be made to the above-described embodiments. It is apparent from the description that embodiments added with such alterations or improvements can also be included in the technical scope of the present invention, as long as they fall within the scope of the appended claims.

It should be noted that the operations, procedures, steps, stages, and the like of each process performed by an apparatus, system, program, and method shown in the embodiments, or drawings can be realized in any order as long as the order is not indicated by "prior to," "before," or the like and as long as the output from a previous process is not used in a later process. Even if the operation flow is described using phrases such as "first" or "next" in the claims, embodiments, or drawings for convenience, it does not necessarily mean that the process must be performed in this order.

### EXPLANATION OF REFERENCES

10 semiconductor substrate
11 well region
12 emitter region
14 base region
15 contact region
16 accumulation region
18 drift region
20 buffer region
21 upper surface
22 collector region
23 lower surface
24 collector electrode
29 linear portion
30 dummy trench portion
31 edge portion
32 dummy dielectric film
34 dummy conductive portion
38 interlayer dielectric film
39 linear portion
40 gate trench portion
41 edge portion
42 gate dielectric film
44 gate conductive portion
45 trench
52 emitter electrode
54 contact hole
60, 61 mesa portion
70 transistor portion
80 diode portion
81 extension region
82 cathode region
90 edge termination structure portion
100 semiconductor device
130 outer circumferential gate runner
131 active-side gate runner
160 active portion
162 end side
164 gate pad
202 first lower end region
204 separation region
205 second lower end region
207 third lower end region
212 source region
214 fourth lower end region
222 drain region
252 source electrode
300 mask

## Claims

1. A semiconductor device (100) comprising:
a semiconductor substrate (10) that has an upper surface (21) and a lower surface (23), and includes a drift region (18) of a first conductivity type and has an active region (160) and an edge termination region (90) that is provided between the active region (160) and an end side (162) of the semiconductor substrate (10);
a gate runner including an outer circumferential gate runner (130) and an active-side gate runner (131), wherein:
the outer circumferential gate runner (130) is arranged between the active portion (160) and the end side (162) of the semiconductor substrate (10) in top view,
the active-side gate runner (131) is provided in the active portion (160), and
the edge termination structure portion (90) is arranged between the outer circumferential gate runner (130) and the end side (162);
a base region (14) of a second conductivity type that is provided between the drift region (18) and the upper surface (21) of the semiconductor substrate (10);
a plurality of trench portions that are provided from the upper surface (21) of the semiconductor substrate (10) to below the base region (14), and include a gate trench portion (40) and a dummy trench portion (30);
a first lower end region (202) of the second conductivity type that is provided continuously to be in contact with lower ends of two or more trench portions which include the gate trench portion (40);
a well region (11) of the second conductivity type that is provided below the gate runner from the upper surface (21) of the semiconductor substrate (10) to below the base region (14), wherein the well region (11) has a higher doping concentration than the base region (14); and
a separation region (204) that is not overlapped with the first lower end region (202) in a top view and is provided between the well region (11) and the first lower end region(202), wherein
the separation region (204) has a second lower end region (205) of the second conductivity type that is provided to be in contact with lower ends of one or more trench portions including another gate trench portion (40), and
a plurality of second lower end regions (205) in the separation region (204), each being identical to the second lower end region (205), are arranged apart from each other along a longitudinal direction of the gate trench portion (40).

2. The semiconductor device (100) according to claim 1, wherein the number of the trench portions in contact with one of second lower end regions (205), each being identical to the second lower end region (205), is less than the number of the trench portions in contact with one of first lower end regions (202), each being identical to the first lower end region.

3. The semiconductor device (100) according to claim 1, wherein one of the plurality of second lower end regions (205), each being identical to the second lower end region (205), is in contact with a lower end of one of gate trench portions (40), each being identical to the gate trench portion (40), and is not in contact with a lower end of the gate trench portion (40) other than that of the one of the gate trench portions (40).

4. The semiconductor device (100) according to claim 3, wherein one of first lower end regions (202), each being identical to the first lower end region (202), is in contact with lower ends of a plurality of gate trench portions (40), each being identical to the gate trench portion (40), and a plurality of dummy trench portions (30), each being identical to the dummy trench portion (30).

5. The semiconductor device (100) according to claim 3, wherein one of the plurality of second lower end regions (205), each being identical to the second lower end region (205), is in contact with a lower end of one of the gate trench portions (40), each being identical to the gate trench portion (40), and is not in contact with a lower end of the trench portion that is arranged adjacent to the gate trench portion (40).

6. The semiconductor device (100) according to claim 5, further comprising:
a third lower end region (207) of the second conductivity type that is provided to be in contact with the lower end of the dummy trench portion (30), wherein
the dummy trench portion (30) with which the third lower end region (207) is in contact is arranged adjacent to the gate trench portion (40) with which the second lower end region (205) is in contact; and
the third lower end region (207) is separated from all of the first lower end region (202), the second lower end region (205) and the well region (11).

7. The semiconductor device (100) according to any one of claim 1 to 4, wherein
the separation region (204) is sandwiched by two of first lower end regions (202), each being identical to the first lower end region (202), in a top view.

8. The semiconductor device (100) according to claim 3, wherein the gate trench portion (40) includes:
a gate dielectric film (42); and
a gate conductive portion (44) that is insulated from the semiconductor substrate (10) by the gate dielectric film (42), wherein
the gate conductive portion (44) at at least one among the gate trench portions (40) in contact with the second lower end region (205) is shorter than the gate conductive portion (44) of the gate trench portion (40) in contact with the first lower end region (202) in a depth direction.

9. The semiconductor device (100) according to any one of claim 1 to 4, wherein
two or more of the dummy trench portions (30) that are not in contact with the first lower end region (202) and the second lower end region (205) are arranged in series adjacent to the gate trench portion (40) that is in contact with the first lower end region (202); and
the semiconductor device (100) further comprises a fourth lower end region (214) of the second conductivity type that is provided to be in contact with the lower ends of the two or more of the dummy trench portions (30) arranged in series.

10. The semiconductor device (100) according to any one of claim 1 to 4, wherein the gate trench portion (40) includes:
a gate dielectric film (42); and
a gate conductive portion (44) that is insulated from the semiconductor substrate (10) by the gate dielectric film (42), wherein
at at least one of the gate trench portions (40) in contact with the second lower end region (205), the gate conductive portion (44) at a position in contact with the gate dielectric film (42) is longer than the gate conductive portion (44) at a position that is the farthest from the gate dielectric film (42) in a depth direction.

11. The semiconductor device (100) according to any one of claim 1 to 4, wherein at least one of the gate trench portions (40) in contact with the second lower end region (205) is shorter than the gate trench portion (40) in contact with the first lower end region (202) in a depth direction.

12. The semiconductor device (100) according to any one of claim 1 to 4, wherein
at least one of first lower end regions (202), each being identical to the first lower end region (202), is provided to be in contact with the lower end of the dummy trench portion (30);
the separation region (204) includes one or more of the dummy trench portions (30); and
at least one of the dummy trench portions (30) of the separation region (204) is longer than the dummy trench portion (30) in contact with the first lower end region (202) in a depth direction.

13. The semiconductor device (100) according to any one of claim 1 to 4, further comprising:
an emitter region (12) of the first conductivity type that is exposed on the upper surface (21) of the semiconductor substrate (10), is provided to be in contact with the gate trench portion (40), and has a doping concentration higher than that of the drift region (18); and
a contact region (15) of the second conductivity type that is exposed on the upper surface (21) of the semiconductor substrate (10), is alternately arranged with the emitter region (12) along a longitudinal direction of the gate trench portion (30), and has a doping concentration higher than that of the base region (14); wherein
the second lower end region (205) is arranged to overlap with the emitter region (12) in a top view.

14. The semiconductor device (100) according to claim 13, further comprising
a collector region (22) of the second conductivity type that is provided to be in contact with the lower surface (23) of the semiconductor substrate (10).

15. The semiconductor device (100) according to any one of claim 1 to 4, further comprising:
a source region (212) of the first conductivity type that is exposed on the upper surface (21) of the semiconductor substrate (10), is provided to be in contact with the gate trench portion (40), and has a doping concentration higher than that of the drift region (18); and
a contact region (15) of the second conductivity type that is exposed on the upper surface (21) of the semiconductor substrate (10), is alternately arranged with the source region (212) along a longitudinal direction of the gate trench portion (40), and has a doping concentration higher than that of the base region (14); wherein
the second lower end region (205) is arranged to overlap with the source region (212) in a top view.

16. The semiconductor device (100) according to claim 15, further comprising
a drain region (222) of the first conductivity type that is provided to be in contact with the lower surface (23) of the semiconductor substrate (10).

17. The semiconductor device (100) according to any one of claim 1 to 4, wherein for each of two or more of the gate trench portions (40), the second lower end region (205) being separated from each other is provided.

18. The semiconductor device (100) according to claim 1, wherein the gate trench portion (40) in contact with the second lower end region (205) is shorter than at least another one of gate trench portions (40), each being identical to the gate trench portion (40), in a depth direction.

## Patentansprüche

1. Halbleitervorrichtung (100), umfassend:
ein Halbleitersubstrat (10), das eine obere Fläche (21) und eine untere Fläche (23) aufweist und eine Driftregion (18) eines ersten Leitfähigkeitstyps umfasst und eine aktive Region (160) und eine Randabschlussregion (90) aufweist, die zwischen der aktiven Region (160) und einer Endseite (162) des Halbleitersubstrats (10) vorgesehen ist;
einen Gateläufer einschließlich eines Außenumfangsgateläufers (130) und eines Aktivseitengateläufers (131), wobei:
der Außenumfangsgateläufer (130) in der Draufsicht zwischen dem aktiven Abschnitt (160) und der Endseite (162) des Halbleitersubstrats (10) angeordnet ist,
der Aktivseitengateläufer (131) in dem aktiven Abschnitt (160) vorgesehen ist und
der Randabschlussstrukturabschnitt (90) zwischen dem Außenumfangsgateläufer (130) und der Endseite (162) angeordnet ist;
eine Basisregion (14) eines zweiten Leitfähigkeitstyps, die zwischen der Driftregion (18) und der oberen Fläche (21) des Halbleitersubstrats (10) vorgesehen ist;
mehrere Grabenabschnitte, die von der oberen Fläche (21) des Halbleitersubstrats (10) bis unterhalb der Basisregion (14) vorgesehen sind und einen Gategrabenabschnitt (40) und einen Dummygrabenabschnitt (30) umfassen;
eine erste untere Endregion (202) des zweiten Leitfähigkeitstyps, die durchgehend vorgesehen ist, sodass sie mit unteren Enden von zwei oder mehr Grabenabschnitten in Kontakt ist, die den Gategrabenabschnitt (40) umfassen;
eine Wannenregion (11) des zweiten Leitfähigkeitstyps, die unterhalb des Gateläufers von der oberen Fläche (21) des Halbleitersubstrats (10) bis unterhalb der Basisregion (14) vorgesehen ist, wobei die Wannenregion (11) eine höhere Dotierungskonzentration als die Basisregion (14) aufweist; und
eine Trennregion (204), die sich in der Draufsicht nicht mit der ersten unteren Endregion (202) überlappt und zwischen der Wannenregion (11) und der ersten unteren Endregion (202) vorgesehen ist, wobei
die Trennregion (204) eine zweite untere Endregion (205) des zweiten Leitfähigkeitstyps aufweist, die derart vorgesehen ist, dass sie mit unteren Enden von einem oder mehreren Grabenabschnitten einschließlich eines weiteren Gategrabenabschnitts (40) in Kontakt ist, und
mehrere zweite untere Endregionen (205) in der Trennregion (204), die jeweils mit der zweiten unteren Endregion (205) identisch sind und entlang einer Längsrichtung des Gategrabenabschnitts (40) voneinander beabstandet angeordnet sind.

2. Halbleitervorrichtung (100) nach Anspruch 1, wobei die Anzahl der Grabenabschnitte, die mit einer der zweiten unteren Endregionen (205) in Kontakt ist, die jeweils mit der zweiten unteren Endregion (205) identisch sind, kleiner ist als die Anzahl der Grabenabschnitte, die mit einer der ersten unteren Endregionen (202) in Kontakt ist, die jeweils mit der ersten unteren Endregion identisch sind.

3. Halbleitervorrichtung (100) nach Anspruch 1, wobei eine der mehreren zweiten unteren Endregionen (205), die jeweils mit der zweiten unteren Endregion (205) identisch sind, mit einem unteren Ende von einem der Gategrabenabschnitte (40) in Kontakt ist, die jeweils mit dem Gategrabenabschnitt (40) identisch sind, und mit keinem anderen unteren Ende des Gategrabenabschnitts (40) in Kontakt ist als dem einen der Gategrabenabschnitte (40).

4. Halbleitervorrichtung (100) nach Anspruch 3, wobei eine der ersten unteren Endregionen (202), die jeweils mit der ersten unteren Endregion (202) identisch sind, mit den unteren Enden von mehreren Gategrabenabschnitten (40), die jeweils mit dem Gategrabenabschnitt (40) identisch sind, und mehreren Dummygrabenabschnitten (30), die jeweils mit dem Dummygrabenabschnitt (30) identisch sind, in Kontakt ist.

5. Halbleitervorrichtung (100) nach Anspruch 3, wobei eine der mehreren zweiten unteren Endregionen (205), die jeweils mit der zweiten unteren Endregion (205) identisch sind, mit einem unteren Ende von einem der Gategrabenabschnitte (40) in Kontakt ist, die jeweils mit dem Gategrabenabschnitt (40) identisch sind, und nicht mit einem unteren Ende des Grabenabschnitts in Kontakt ist, der neben dem Gategrabenabschnitt (40) angeordnet ist.

6. Halbleitervorrichtung (100) nach Anspruch 5, ferner umfassend:
eine dritte untere Endregion (207) des zweiten Leitfähigkeitstyps, die derart vorgesehen ist, dass sie mit dem unteren Ende des Dummygrabenabschnitts (30) in Kontakt ist, wobei
der Dummygrabenabschnitt (30), mit dem die dritte untere Endregion (207) in Kontakt ist, neben dem Gategrabenabschnitt (40) angeordnet ist, mit dem die zweite untere Endregion (205) in Kontakt ist; und
die dritte untere Endregion (207) von allen von der ersten unteren Endregion (202), der zweiten unteren Endregion (205) und der Wannenregion (11) getrennt ist.

7. Halbleitervorrichtung (100) nach einem der Ansprüche 1 bis 4, wobei
die Trennregion (204) in einer Draufsicht zwischen zwei von ersten unteren Endregionen (202) angeordnet ist, die jeweils mit der ersten unteren Endregion (202) identisch sind.

8. Halbleitervorrichtung (100) nach Anspruch 3, wobei der Gategrabenabschnitt (40) umfasst:
einen Gatedielektrikumfilm (42); und
einen leitfähigen Gateabschnitt (44), der durch den Gatedielektrikumfilm (42) von dem Halbleitersubstrat (10) isoliert ist, wobei
der leitfähige Gateabschnitt (44) an mindestens einem der Gategrabenabschnitte (40), der mit der zweiten unteren Endregion (205) in Kontakt ist, in Tiefenrichtung kürzer ist als der leitfähige Gateabschnitt (44) des Gategrabenabschnitts (40), der mit der ersten unteren Endregion (202) in Kontakt ist.

9. Halbleitervorrichtung (100) nach einem der Ansprüche 1 bis 4, wobei
zwei oder mehr der Dummygrabenabschnitte (30), die nicht mit der ersten unteren Endregion (202) und der zweiten unteren Endregion (205) in Kontakt sind, in Reihe neben dem Gategrabenabschnitt (40) angeordnet sind, der mit der ersten unteren Endregion (202) in Kontakt ist; und
die Halbleitervorrichtung (100) ferner eine vierte untere Endregion (214) des zweiten Leitfähigkeitstyps umfasst, die derart vorgesehen ist, dass sie mit den unteren Enden der zwei oder mehr in Reihe angeordneten Dummygrabenabschnitte (30) in Kontakt ist.

10. Halbleitervorrichtung (100) nach einem der Ansprüche 1 bis 4, wobei der Gategrabenabschnitt (40) umfasst:
einen Gatedielektrikumfilm (42); und
einen leitfähigen Gateabschnitt (44), der mittels des Gatedielektrikumfilms (42) von dem Halbleitersubstrat (10) isoliert ist, wobei
bei mindestens einem der Gategrabenabschnitte (40), der mit der zweiten unteren Endregion (205) in Kontakt ist, der leitfähige Gateabschnitt (44) an einer Position, die mit dem Gatedielektrikumfilm (42) in Kontakt ist, länger ist als der leitfähige Gateabschnitt (44) an einer Position, die sich in Tiefenrichtung am weitesten von dem Gatedielektrikumfilm (42) entfernt befindet.

11. Halbleitervorrichtung (100) nach einem der Ansprüche 1 bis 4, wobei mindestens einer der Gategrabenabschnitte (40), der mit der zweiten unteren Endregion (205) in Kontakt ist, in Tiefenrichtung kürzer ist als der Gategrabenabschnitt (40), der mit der ersten unteren Endregion (202) in Kontakt ist.

12. Halbleitervorrichtung (100) nach einem der Ansprüche 1 bis 4, wobei
mindestens eine der ersten unteren Endregionen (202), die jeweils mit der ersten unteren Endregion (202) identisch sind, derart vorgesehen ist, dass sie mit dem unteren Ende des Dummygrabenabschnitts (30) in Kontakt ist;
die Trennregion (204) einen oder mehrere der Dummygrabenabschnitte (30) umfasst; und
mindestens einer der Dummygrabenabschnitte (30) der Trennregion (204) in Tiefenrichtung länger ist als der Dummygrabenabschnitt (30), der mit der ersten unteren Endregion (202) in Kontakt ist.

13. Halbleitervorrichtung (100) nach einem der Ansprüche 1 bis 4, ferner umfassend:
eine Emitterregion (12) des ersten Leitfähigkeitstyps, die an der oberen Fläche (21) des Halbleitersubstrats (10) freiliegt und derart vorgesehen ist, dass sie mit dem Gategrabenabschnitt (40) in Kontakt ist, und die eine höhere Dotierungskonzentration aufweist als die der Driftregion (18); und
eine Kontaktregion (15) des zweiten Leitfähigkeitstyps, die an der oberen Fläche (21) des Halbleitersubstrats (10) freiliegt, mit der Emitterregion (12) entlang einer Längsrichtung des Gategrabenabschnitts (30) abwechselnd angeordnet ist und eine höhere Dotierungskonzentration als die Basisregion (14) aufweist; wobei
die zweite untere Endregion (205) derart angeordnet ist, dass sie sich in einer Draufsicht mit der Emitterregion (12) überlappt.

14. Halbleitervorrichtung (100) nach Anspruch 13, ferner umfassend
eine Kollektorregion (22) des zweiten Leitfähigkeitstyps, die derart vorgesehen ist, dass sie mit der unteren Fläche (23) des Halbleitersubstrats (10) in Kontakt ist.

15. Halbleitervorrichtung (100) nach einem der Ansprüche 1 bis 4, ferner umfassend:
eine Source-Region (212) des ersten Leitfähigkeitstyps, die an der oberen Fläche (21) des Halbleitersubstrats (10) freiliegt und derart vorgesehen ist, dass sie mit dem Gategrabenabschnitt (40) in Kontakt ist, und eine höhere Dotierungskonzentration aufweist als die Driftregion (18); und
eine Kontaktregion (15) des zweiten Leitfähigkeitstyps, die an der oberen Fläche (21) des Halbleitersubstrats (10) freiliegt, mit der Source-Region (212) entlang einer Längsrichtung des Gategrabenabschnitts (40) abwechselnd angeordnet ist und eine höhere Dotierungskonzentration aufweist als die Basisregion (14); wobei
die zweite untere Endregion (205) derart angeordnet ist, dass sie sich in einer Draufsicht mit der Source-Region (212) überlappt.

16. Halbleitervorrichtung (100) nach Anspruch 15, ferner umfassend
eine Drain-Region (222) des ersten Leitfähigkeitstyps, die derart vorgesehen ist, dass sie mit der unteren Fläche (23) des Halbleitersubstrats (10) in Kontakt ist.

17. Halbleitervorrichtung (100) nach einem der Ansprüche 1 bis 4, wobei für jeden von zwei oder mehr der Gategrabenabschnitte (40) die zweite untere Endregion (205) voneinander getrennt vorgesehen ist.

18. Halbleitervorrichtung (100) nach Anspruch 1, wobei der Gategrabenabschnitt (40), der mit der zweiten unteren Endregion (205) in Kontakt ist, in Tiefenrichtung kürzer ist als mindestens ein weiterer der Gategrabenabschnitte (40), die jeweils mit dem Gategrabenabschnitt (40) identisch sind.

## Revendications

1. Dispositif semi-conducteur (100) comprenant :
un substrat semi-conducteur (10) qui présente une surface supérieure (21) et une surface inférieure (23), incluant une région de dérive (18) d'un premier type de conductivité et comporte une partie active (160) ainsi qu'une région de terminaison de bord (90) qui est prévue entre la partie active (160) et un côté d'extrémité (162) du substrat semi-conducteur (10) ;
une piste de grille incluant une piste de grille périphérique externe (130) et une piste de grille côté actif (131), dans lequel :
la piste de grille périphérique externe (130) est disposée entre la partie active (160) et le côté d'extrémité (162) du substrat semi-conducteur (10) en vue de dessus,
la piste de grille côté actif (131) est prévue dans la partie active (160) et
la région de terminaison de bord (90) est disposée entre la piste de grille périphérique externe (130) et le côté d'extrémité (162) ;
une région de base (14) d'un deuxième type de conductivité, qui est prévue entre la région de dérive (18) et la surface supérieure (21) du substrat semi-conducteur (10) ;
une pluralité de parties de tranchée qui s'étendent depuis la surface supérieure (21) du substrat semi-conducteur (10) jusqu'au-dessous de la région de base (14) et incluent une partie de tranchée de grille (40) et une partie de tranchée factice (30) ;
une première région d'extrémité inférieure (202) du deuxième type de conductivité, qui est prévue de manière continue pour être en contact avec les extrémités inférieures de deux ou plusieurs parties de tranchée incluant la partie de tranchée de grille (40) ;
une région de puits (11) du deuxième type de conductivité, qui est prévue sous la piste de grille et s'étend depuis la surface supérieure (21) du substrat semi-conducteur (10) jusqu'au-dessous de la région de base (14), dans lequel la région de puits (11) présente une concentration de dopage supérieure à celle de la région de base (14) ; et
une région de séparation (204) qui ne se superpose pas à la première région d'extrémité inférieure (202) en vue de dessus et qui est prévue entre la région de puits (11) et la première région d'extrémité inférieure (202), dans lequel la région de séparation (204) comporte une deuxième région d'extrémité inférieure (205) du deuxième type de conductivité, qui est prévue pour être en contact avec les extrémités inférieures d'une ou plusieurs parties de tranchée incluant une autre partie de tranchée de grille (40) et
une pluralité de deuxièmes régions d'extrémité inférieure (205) dans la région de séparation (204), étant chacune identique à la deuxième région d'extrémité inférieure (205), sont disposées à distance les unes des autres le long d'une direction longitudinale de la partie de tranchée de grille (40).

2. Dispositif semi-conducteur (100) selon la revendication 1, dans lequel le nombre de parties de tranchée en contact avec l'une des deuxièmes régions d'extrémité inférieure (205), étant chacune identique à la deuxième région d'extrémité inférieure (205), est inférieur au nombre de parties de tranchée en contact avec l'une des premières régions d'extrémité inférieure (202), étant chacune identique à la première région d'extrémité inférieure.

3. Dispositif semi-conducteur (100) selon la revendication 1, dans lequel l'une de la pluralité de deuxièmes régions d'extrémité inférieure (205), étant chacune identique à la deuxième région d'extrémité inférieure (205), est en contact avec une extrémité inférieure de l'une des parties de tranchée de grille (40), étant chacune identique à la partie de tranchée de grille (40), et n'est pas en contact avec une extrémité inférieure d'une partie de tranchée de grille (40) autre que celle de l'une des parties de tranchée de grille (40).

4. Dispositif semi-conducteur (100) selon la revendication 3, dans lequel l'une des premières régions d'extrémité inférieure (202), étant chacune identique à la première région d'extrémité inférieure (202), est en contact avec les extrémités inférieures d'une pluralité de parties de tranchée de grille (40), étant chacune identique à la partie de tranchée de grille (40) et d'une pluralité de parties de tranchée factices (30), étant chacune identique à la partie de tranchée factice (30).

5. Dispositif semi-conducteur (100) selon la revendication 3, dans lequel l'une des deuxièmes régions d'extrémité inférieure (205), étant chacune identique à la deuxième région d'extrémité inférieure (205), est en contact avec une extrémité inférieure de l'une des parties de tranchée de grille (40), étant chacune identique à la partie de tranchée de grille (40), et n'est pas en contact avec une extrémité inférieure de la partie de tranchée disposée de manière adjacente à la partie de tranchée de grille (40).

6. Dispositif semi-conducteur (100) selon la revendication 5, comprenant en outre :
une troisième région d'extrémité inférieure (207) du deuxième type de conductivité, qui est prévue pour être en contact avec l'extrémité inférieure de la partie de tranchée factice (30), dans lequel
la partie de tranchée factice (30) avec laquelle la troisième région d'extrémité inférieure (207) est en contact est disposée de manière adjacente à la partie de tranchée de grille (40) avec laquelle la deuxième région d'extrémité inférieure (205) est en contact ; et
la troisième région d'extrémité inférieure (207) est séparée de la première région d'extrémité inférieure (202), de la deuxième région d'extrémité inférieure (205) et de la région de puits (11).

7. Dispositif semi-conducteur (100) selon une quelconque des revendications 1 à 4, dans lequel
la région de séparation (204) est intercalée entre deux premières régions d'extrémité inférieure (202), étant chacune identique à la première région d'extrémité inférieure (202), en vue de dessus.

8. Dispositif semi-conducteur (100) selon la revendication 3, dans lequel la partie de tranchée de grille (40) comprend :
un film diélectrique de grille (42) ; et
une partie conductrice de grille (44) qui est isolée du substrat semi-conducteur (10) par le film diélectrique de grille (42), dans lequel
la partie conductrice de grille (44), au niveau d'au moins une des parties de tranchée de grille (40) en contact avec la deuxième région d'extrémité inférieure (205), est plus courte que la partie conductrice de grille (44) de la partie de tranchée de grille (40) en contact avec la première région d'extrémité inférieure (202), dans une direction de profondeur.

9. Dispositif semi-conducteur (100) selon une quelconque des revendications 1 à 4, dans lequel
deux ou plusieurs des parties de tranchée factices (30) qui ne sont pas en contact avec la première région d'extrémité inférieure (202) et la deuxième région d'extrémité inférieure (205) sont disposées en série de manière adjacente à la partie de tranchée de grille (40) qui est en contact avec la première région d'extrémité inférieure (202) ; et
le dispositif semi-conducteur (100) comprend en outre une quatrième région d'extrémité inférieure (214) du deuxième type de conductivité, qui est prévue pour être en contact avec les extrémités inférieures des deux ou plusieurs parties de tranchée factices (30) disposées en série.

10. Dispositif semi-conducteur (100) selon une quelconque des revendications 1 à 4, dans lequel la partie de tranchée de grille (40) comprend :
un film diélectrique de grille (42) ; et
une partie conductrice de grille (44) qui est isolée du substrat semi-conducteur (10) par le film diélectrique de grille (42), dans lequel
au niveau d'au moins une des parties de tranchée de grille (40) en contact avec la deuxième région d'extrémité inférieure (205), la partie conductrice de grille (44), à une position en contact avec le film diélectrique de grille (42), est plus longue que la partie conductrice de grille (44), à une position la plus éloignée du film diélectrique de grille (42), dans une direction de profondeur.

11. Dispositif semi-conducteur (100) selon une quelconque des revendications 1 à 4, dans lequel au moins une des parties de tranchée de grille (40) en contact avec la deuxième région d'extrémité inférieure (205) est plus courte que la partie de tranchée de grille (40) en contact avec la première région d'extrémité inférieure (202) dans une direction de profondeur.

12. Dispositif semi-conducteur (100) selon une quelconque des revendications 1 à 4, dans lequel
au moins une des premières régions d'extrémité inférieure (202), étant chacune identique à la première région d'extrémité inférieure (202), est prévue pour être en contact avec l'extrémité inférieure de la partie de tranchée factice (30) ;
la région de séparation (204) comprend une ou plusieurs des parties de tranchée factices (30) ; et
au moins une des parties de tranchée factices (30) de la région de séparation (204) est plus longue que la partie de tranchée factice (30) en contact avec la première région d'extrémité inférieure (202) dans une direction de profondeur.

13. Dispositif semi-conducteur (100) selon une quelconque des revendications 1 à 4, comprenant en outre :
une région d'émetteur (12) du premier type de conductivité qui est exposée sur la surface supérieure (21) du substrat semi-conducteur (10), est prévue pour être en contact avec la partie de tranchée de grille (40), et présente une concentration de dopage supérieure à celle de la région de dérive (18) ; et
une région de contact (15) du deuxième type de conductivité qui est exposée sur la surface supérieure (21) du substrat semi-conducteur (10), est disposée en alternance avec la région d'émetteur (12) le long d'une direction longitudinale de la partie de tranchée de grille (30), et présente une concentration de dopage supérieure à celle de la région de base (14) ; dans lequel
la deuxième région d'extrémité inférieure (205) est disposée de manière à se superposer à la région d'émetteur (12) en vue de dessus.

14. Dispositif semi-conducteur (100) selon la revendication 13, comprenant en outre une région de collecteur (22) du deuxième type de conductivité, qui est prévue pour être en contact avec la surface inférieure (23) du substrat semi-conducteur (10).

15. Dispositif semi-conducteur (100) selon une quelconque des revendications 1 à 4, comprenant en outre :
une région de source (212) du premier type de conductivité qui est exposée sur la surface supérieure (21) du substrat semi-conducteur (10), qui est prévue pour être en contact avec la partie de tranchée de grille (40) et qui présente une concentration de dopage supérieure à celle de la région de dérive (18) ; et
une région de contact (15) du deuxième type de conductivité qui est exposée sur la surface supérieure (21) du substrat semi-conducteur (10), qui est disposée en alternance avec la région de source (212) le long d'une direction longitudinale de la partie de tranchée de grille (40) et qui présente une concentration de dopage supérieure à celle de la région de base (14) ;
dans lequel
la deuxième région d'extrémité inférieure (205) est disposée de manière à se superposer à la région de source (212) en vue de dessus.

16. Dispositif semi-conducteur (100) selon la revendication 15, comprenant en outre
une région de drain (222) du premier type de conductivité, qui est prévue pour être en contact avec la surface inférieure (23) du substrat semi-conducteur (10).

17. Dispositif semi-conducteur (100) selon une quelconque des revendications 1 à 4, dans lequel, pour chacune de deux ou plusieurs des parties de tranchée de grille (40), la deuxième région d'extrémité inférieure (205), séparée des autres, est prévue.

18. Dispositif semi-conducteur (100) selon la revendication 1, dans lequel la partie de tranchée de grille (40) en contact avec la deuxième région d'extrémité inférieure (205) est plus courte, dans une direction de profondeur, qu'au moins une autre des parties de tranchée de grille (40), étant chacune identique à la partie de tranchée de grille (40).
